# EUROPEAN PATENT APPLICATION

(11) **EP 4 686 349 A1**
(43) Date of publication of application: **28.01.2026**
(21) Application number: 24915028.5
(22) Date of filing: 27.11.2024
(51) Int. Cl.: H10F 77/20

(54) **SOLAR CELL AND PREPARATION METHOD THEREFOR, AND PHOTOVOLTAIC MODULE**

(30) Priority: 05.01.2024 CN 202410017395
(71) Applicant: Tongwei Solar (Meishan) Co., Ltd., Meishan, Sichuan 620041 (CN)
(72) Inventor: ZHOU, Fan, Meishan, Sichuan 620041 (CN); ZHOU, Hua, Meishan, Sichuan 620041 (CN); HE, Yu, Meishan, Sichuan 620041 (CN)
(74) Representative: Zacco Denmark A/S
(86) International application number: PCT/CN2024/134828
(87) International publication number: WO 2025/145812

(57) **Abstract**

The present invention relates to a solar cell and a preparation method therefor, and a photovoltaic module. The solar cell comprises: an N-type substrate; a patterned first passivation contact structure, which is arranged on a light-receiving surface of the substrate, and comprises a first dielectric layer having a thickness less than or equal to 2 nm and an N-type first doped polysilicon layer; a second passivation contact structure, which is arranged on the entire backlight surface of the substrate, and comprises a second dielectric layer having a thickness greater than 2 nm and having a through hole and a P-type second doped polysilicon layer having a doping concentration of 5×10¹⁸ to 3×10²⁰ atom/cm³; a first functional layer on the substrate and the first passivation contact structure; a second functional layer on the second doped polysilicon layer; a first electrode, which penetrates the first functional layer to make ohmic contact with the first doped polysilicon layer; and a second electrode, which penetrates the second functional layer to make ohmic contact with the second doped polysilicon layer.

## Description

This application claims priority to Chinese patent application No. 202410017395.X, entitled "SOLAR CELL AND PREPARATION METHOD THEREFOR, AND PHOTOVOLTAIC MODULE" filed on January 05, 2024, the content of which is hereby incorporated by reference in its entirety.

### TECHNICAL FIELD

The present application relates to the technical field of solar cells, and in particular, to a solar cell, a method for preparing the same, and a photovoltaic module.

### BACKGROUND

Passivated contact solar cells exhibit relatively high photoelectric conversion efficiency among current solar cells and are suitable for industrial application and promotion. However, when manufactured using industrialized production methods, their photoelectric conversion efficiency hits a bottleneck, currently at approximately 25.1%. Due to limitations such as the recombination losses and current transmission losses at the light-receiving surface of these cells, further improvement in photoelectric conversion efficiency is difficult.

### SUMMARY

To address the above technical issues, embodiments of the present application provide a solar cell, a preparation method thereof, and a photovoltaic module, aiming to address the difficulty in breaking through the photoelectric conversion efficiency bottleneck of passivated contact solar cells encountered in existing technologies.

In a first aspect, the present application provides a solar cell, which includes:
a substrate having an N-type conductivity;
a patterned first passivating contact structure disposed on a light-receiving surface of the substrate, the first passivating contact structure including a first dielectric layer disposed adjacent to the substrate, and a first doped polysilicon layer disposed away from the substrate and having the N-type conductivity, wherein a thickness of the first dielectric layer is less than or equal to 2 nm;
a second passivating contact structure disposed on an entirety of a back surface of the substrate, the second passivating contact structure including a second dielectric layer disposed adjacent to the substrate and a second doped polysilicon layer disposed away from the substrate, the second doped polysilicon layer having a P-type conductivity different from the N-type conductivity to form a PN junction between the second doped polysilicon layer and the substrate, wherein a thickness of the second dielectric layer is greater than 2 nm, the second dielectric layer has a through-hole that communicates the substrate with the second doped polysilicon layer, and a doping concentration of a P-type conductive element in the second doped polysilicon layer is in a range from 5×10¹⁸ atoms/cm³ to 3×10²⁰ atoms/cm³;
a first function layer disposed on the light-receiving surface of the substrate and a surface of the first doped polysilicon layer away from the substrate;
a second function layer disposed on a surface of the second doped polysilicon layer away from the substrate;
a first electrode extending through the first function layer and forming an ohmic contact with the first doped polysilicon layer, wherein a patterned region of the first passivating contact structure is disposed corresponding to a patterned region of the first electrode; and
a second electrode extending through the second function layer and forming an ohmic contact with the second doped polysilicon layer.

Furthermore, a region of the substrate covered by the first passivating contact structure is 0.5 µm to 1.5 µm thicker than another region of the substrate uncovered by the first passivating contact structure.

Furthermore, a diameter of the through-hole is in a range from 50 nm to 500 nm, and a number of the through-holes is in a range from 1×10⁴ /cm² to 1.6×10⁸ /cm².

Furthermore, a thickness of the first doped polysilicon layer is in a range from 40 nm to 200 nm.

Furthermore, a thickness of the second doped polysilicon layer is in a range from 200 nm to 400 nm.

Furthermore, the first doped polysilicon layer is doped with an N-type conductive element, wherein the N-type conductive element includes at least one of a phosphorus element, a germanium element, or a selenium element.

Furthermore, the P-type conductive element includes at least one of a boron element, an indium element, or a gallium element.

Furthermore, a width of the first passivating contact structure is in a range from 20 µm to 110 µm.

Furthermore, the first function layer includes a first passivation layer disposed adjacent to the substrate and a first anti-reflection layer disposed away from the substrate.

Furthermore, the second function layer includes a second passivation layer disposed adjacent to the second doped polysilicon layer and a second anti-reflection layer disposed away from the second doped polysilicon layer.

Furthermore, a quantity ratio of gridlines of the second electrode to gridlines of the first electrode is in a range from 1.2:1 to 1.6:1.

In a second aspect, embodiments of the present application provide a method for preparing the solar cell as described in the first aspect, including the following steps:
forming the passivating contact structure: forming a first passivating contact structure by disposing the first dielectric layer and a first doped amorphous silicon layer in sequence on a light-receiving surface of the substrate, and forming a second passivating contact structure by disposing the second dielectric layer and a second doped amorphous silicon layer in sequence on the back surface of the substrate, wherein a thickness of the first dielectric layer is less than or equal to 2 nm and a thickness of the second dielectric layer is greater than 2 nm;
annealing and patterning treatments: annealing the substrate on which the first passivating contact structure and/or the second passivating contact structure are formed to convert the first doped amorphous silicon layer into the first doped polysilicon layer, and/or to convert the second doped amorphous silicon layer into the second doped polysilicon layer, and patterning the first passivating contact structure to obtain a patterned first passivating contact structure; and
post-treatment: forming the first function layer on the light-receiving surface of the substrate and the patterned first doped polysilicon layer and the second function layer on the second doped polysilicon layer, and fabricating the first electrode on the first function layer and the second electrode on the second function layer.

Furthermore, the step of forming the passivating contact structure includes:
alkali polishing: polishing the light-receiving surface and the back surface of the substrate using a first alkali agent;
depositing the second passivating contact structure: depositing the second dielectric layer and the second doped amorphous silicon layer in sequence on the back surface of the substrate;
texturing: removing the second doped amorphous silicon layer and the second dielectric layer that wrap around the light-receiving surface and edges using a first acid agent, and then texturing the light-receiving surface of the substrate using a second alkali agent; and
depositing the first passivating contact structure: depositing the first dielectric layer and the first doped amorphous silicon layer in sequence on the textured light-receiving surface.

Furthermore, the step of depositing the second passivating contact structure includes depositing the second dielectric layer, a back intrinsic layer, a back doped layer doped with the P-type conductive element, and a back mask layer in sequence on the alkali-polished back surface by plasma enhanced chemical vapor deposition (PECVD);

The texturing step includes removing the back mask layer, the back doped layer, the back intrinsic layer, and the second dielectric layer that wrap around the light-receiving surface and edges using the first acid agent, and then texturing the light-receiving surface using the second alkali agent.

The step of depositing the first passivating contact structure includes depositing the first dielectric layer, a front intrinsic layer and a front doped layer doped with a N-type conductive element in sequence on the textured light-receiving surface by PECVD.

Furthermore, the step of annealing and patterning treatments includes:
printing: printing a patterned alkali-resistant paste on a preset region of the front doped layer, and drying to cure the alkali-resistant paste;
cleaning: etching away the first doped amorphous silicon layer, the first dielectric layer and a portion of the substrate uncovered by the preset region of the light-receiving surface using a third alkali agent, then etching away the alkali-resistant paste and the back mask layer on the back surface using a second acid agent, to form a patterned first dielectric layer and a patterned first doped amorphous silicon layer on the light-receiving surface of the substrate, wherein a portion of the substrate located in the preset region is 0.5 µm to 1.5 µm thicker than a portion of the substrate uncovered by the preset region, and the second dielectric layer and the second doped amorphous silicon layer are formed on an entirety of the back surface of the substrate; and
annealing: annealing at 850°C to 1000°C in an inert atmosphere for 90 min to 150 min, to convert the first doped amorphous silicon layer into the first doped polysilicon layer, or to convert the second doped amorphous silicon layer into the second doped polysilicon layer, and to form a PN junction between the substrate and the second doped polysilicon layer.

Furthermore, in the printing step, a width of the printed patterned alkali-resistant paste is in a range from 20 µm to 110 µm, and after printing, drying is performed at a temperature in a range from 150 °C to 250 °C for a time period in a range from 8 seconds to 12 seconds.

Furthermore, in the cleaning step, the third alkali agent includes an alkali metal hydroxide and a texturing additive in a volume ratio from 1:1 to 3:1, and the etching using the third alkali agent is performed at a temperature from 70°C to 90°C for 1 min to 3 min.

Furthermore, in the cleaning step, the second acid agent is a hydrofluoric acid solution with a volume percentage of 4% to 6%.

Furthermore, the step of depositing the second passivating contact structure includes: first forming, on the alkali polished back surface, the second dielectric layer through a thermal oxidation process and then a back intrinsic amorphous silicon layer through LPCVD, and then doping the back intrinsic amorphous silicon layer with a P-type conductive element through a diffusion process, to convert the back intrinsic amorphous silicon layer into the second doped polysilicon layer;
the texturing step includes removing the second doped amorphous silicon layer and the second dielectric layer that wrap around the light-receiving surface and edges using the first acid agent, then texturing the light-receiving surface using the second alkali agent; and
the step of depositing the first passivating contact structure includes depositing the first dielectric layer, a front intrinsic layer, a front doped layer doped with a N-type conductive element, and a front mask layer in sequence on the textured light-receiving surface by PECVD.

Furthermore, the step of annealing and patterning treatments includes:
annealing: annealing at 850°C to 950°C in an inert atmosphere for 90 min to 150 min, to convert the first doped amorphous silicon layer into the first doped polysilicon layer;
printing: printing a patterned acid-resistant paste on a preset region of the front mask layer, and drying to cure the acid-resistant paste;
cleaning: etching away the front mask layer uncovered in the preset region of the light-receiving surface using a third acid agent, then etching away the first doped polysilicon layer, and the first dielectric layer that are not covered in the preset region of the light-receiving surface and the acid-resistant paste using a fourth alkali agent, and removing the remaining front mask layer using a fourth acid agent, to form a patterned first dielectric layer and a patterned first doped amorphous silicon layer on the light-receiving surface of the substrate and a second dielectric layer and a second polysilicon layer on a front of the back surface of the substrate.

Furthermore, in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

Furthermore, in the cleaning step, the third acid agent is a hydrofluoric acid solution with a volume percentage of 4% to 6%.

Furthermore, in the cleaning step, the fourth alkali agent includes an alkali metal hydroxide and a texturing additive in a volume ratio from 1:1 to 3:1, and the etching using the fourth alkali agent is performed at a temperature from 70 °C to 90 °C for 1 min to 3 min.

Furthermore, in the cleaning step, the fourth acid agent is a hydrofluoric acid solution with a volume percentage of 4% to 6%.

Furthermore, the step of forming the passivating contact structure includes:
texturing: texturing the substrate using a fifth alkali agent;
depositing the first passivating contact structure: depositing the first dielectric layer and the first doped amorphous silicon layer in sequence on the textured light-receiving surface;
alkali polishing: removing a portion of the first doped amorphous silicon layer wrapping around the back surface using a fifth acid agent, then polishing the back surface of the substrate using a sixth alkali agent, and removing the remaining first doped amorphous silicon layer and the first dielectric layer that wrap around the back surface and edges; and
depositing the second passivating contact structure: depositing the second dielectric layer, and the second doped amorphous silicon layer in sequence on the back surface.

Furthermore, the step of depositing the first passivating contact structure includes depositing the first dielectric layer, a front intrinsic layer, a front doped layer doped with a N-type conductive element, and a front mask layer in sequence on the textured light-receiving surface by PECVD;
the step of alkali polishing includes removing the front mask layer wrapping around the back surface using the fifth acid agent, then polishing the back surface of the substrate using the sixth alkali agent, and removing the front doped layer, the front intrinsic layer, and the first dielectric layer that wrap around the back surface and edges; and
depositing the second passivating contact structure includes depositing the second dielectric layer, a back intrinsic layer, a back doped layer doped with a P-type conductive element, and a back mask layer in sequence on the alkali-polished back surface by PECVD.

Furthermore, the step of annealing and patterning treatments includes:
annealing: annealing the substrate on which the first and second passivating contact structures are formed at 850°C to 1000°C in an inert atmosphere for 90 min to 150 min;
printing: printing a patterned acid-resistant paste in the preset region of the front mask layer, and drying to cure the acid-resistant paste; and
cleaning: etching away the front mask layer uncovered in the preset region of the light-receiving surface using a sixth acid agent, then etching away the acid-resistant paste, and the first dielectric layer and the first doped amorphous silicon layer that are not covered in the preset region of the light-receiving surface using a seventh alkali agent, and removing the front mask layer and the back mask layer using a seventh acid agent.

Furthermore, in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

Furthermore, in the cleaning step, the sixth acid agent is a hydrofluoric acid solution with a volume percentage of 4% to 6%.

Furthermore, in the cleaning step, the seventh alkali agent includes an alkali metal hydroxide and a texturing additive in a volume ratio from 1:1 to 3:1, and the etching using the seventh alkali agent is performed at a temperature from 70 °C to 90 °C for 1 min to 3 min.

Furthermore, in the cleaning step, the seventh acid agent is a hydrofluoric acid solution with a volume percentage of 4% to 6%.

Furthermore, the first function layer includes a first passivation layer and a first anti-reflection layer, and the second function layer includes a second passivation layer and a second anti-reflection layer. The post-treatment step includes:
depositing the first passivation layer and the second passivation layer on the light-receiving surface and the back surface by ALD, respectively;
depositing the first anti-reflection layer on the first passivation layer and the second anti-reflection layer on the second passivation layer by PECVD;
printing a first electrode on the front surface and forming an ohmic contact between the first electrode and the first doped polysilicon layer located in the preset region; and
printing a second electrode on the back surface and forming an ohmic contact between the second electrode and the second doped polysilicon layer;

Furthermore, in the ALD, the depositing is performed at a temperature in a range from 200 °C to 280 °C, and thicknesses of the first passivation layer and the second passivation layer are deposited to a thickness from 3 nm to 5 nm, respectively.

In a third aspect, embodiments of the present application provide a photovoltaic module, including the solar cell as described in the first aspect, or the solar cell prepared by the method as described in the second aspect.

Compared with the prior art, the present application has the following beneficial effects:

The present application provides a solar cell with composite function that has double-sided passivating contact, a PN junction structure formed on the back surface, a local passivating contact structure on the front surface, and a passivating contact structure on an entirety of the back surface. Due to the multiple structural characteristics, i.e. the front surface having a local passivating contact structure only in the patterned region on which the first electrode is disposed, the entire back surface adopting a passivating contact structure, and the PN junction formed by the second doped polysilicon layer and the substrate on the back surface and having decoupled characteristic, the solar cell of the embodiments in the present application can have both relatively low recombination losses and current transmission losses at the front surface, increasing the photoelectric conversion efficiency of the solar cell to 25.6% or more.

More importantly, based on the above structural features, the layers responsible for carrier transport and passivation in the passivating contact structure of the light-receiving surface and the back surface are controlled for their different thicknesses in the embodiments of the present application, and cooperates with the structural characteristics of N-type doping on the front surface and P-type heavily doping on the back surface, to achieve effective transport of electrons on the light-receiving surface and holes on the back surface. On the light-receiving surface, a first dielectric layer with a thickness less than or equal to 2 nm is used, and the first dielectric layer with a very thin thickness enables the transport of the small-sized electrons via the quantum tunneling effect. On the back surface, a second dielectric layer with a thickness greater than 2 nm cooperates with the second doped polysilicon layer having P-type heavy doping on the back surface. Although carriers can hardly pass through the second dielectric layer via the quantum tunneling effect under this thickness, the through-holes in the second dielectric layer can be utilized as transport channels for direct conduction. Furthermore, the characteristic that the P-type heavily doped polysilicon layer strongly repels electrons ensures that the larger-sized holes can be selectively transported through the through-holes, and the smaller-sized electrons are blocked, thereby allowing direct transportation of holes between the second doped polysilicon layer and the substrate. Additionally, due to the greater thickness of the second dielectric layer, it also provides excellent passivation effect.

### BRIEF DESCRIPTION OF THE DRAWINGS

To illustrate the technical solutions of the embodiments of the present application more clearly, the drawings used in the embodiments will be described briefly. Apparently, the following described drawings are merely for some embodiments of the present application, and other drawings can be derived from these drawings by those of ordinary skill in the art without any creative effort.
FIG. 1 is a schematic structural view of a solar cell according to an embodiment of the present application.
FIG. 2 is an enlarged schematic view of the structure at position A in FIG. 1.
FIG. 3 is a flowchart of a method for preparing the solar cell in Example 1.
FIG. 4 is a flowchart of a method for preparing the solar cell in Example 2.
FIG. 5 is a flowchart of a method for preparing the solar cell in Example 3.

Reference signs: 1: substrate; 2: first passivating contact structure; 21: first dielectric layer; 22: first doped polysilicon layer; 3: second passivating contact structure; 31: second dielectric layer; 311: through-hole; 32: second doped polysilicon layer; 4: first function layer; 41: first passivation layer; 42: first anti-reflection layer; 5: second function layer; 51: second passivation layer; 52: second anti-reflection layer; 6: first electrode; 7: second electrode.

### DETAILED DESCRIPTION

The technical solutions of the embodiments of the present application will be described more clearly and comprehensively below in conjunction with the accompanying drawings for the embodiments of the present application. Apparently, the embodiments described herein are only part of, not all of the embodiments of the present application. Base on the embodiments of the present application, other embodiments obtained by those of ordinary skill in the art without creative efforts shall fall within the protection scope of the present application.

In the present application, the orientation or position relationships indicated by the terms "upper", "lower", "left", "right", "front", "back", "top", "bottom", "inner", "outer", "central", "vertical", "horizontal", "transverse", "longitudinal", and the like are based on the orientation or position relationships shown in the accompanying drawings and are intended to facilitate the description of the present application and the embodiments, rather than indicating or implying that the apparatus, element, or component referred to must have a particular orientation or be constructed and operated in a particular orientation.

Moreover, in addition to indicating orientation or position relationships, the aforementioned terms can also be used to express other meanings. For example, the term "upper" may, in certain contexts, be used to denote a type of attachment or connection relationship. The specific meanings of these terms in the present application can be understood based on specific circumstances by those of ordinary skills in the art.

In addition, the terms "install", "dispose", "provided with", "connect", and "join" should be interpreted in a broad sense. For example, they may refer to a fixed connection, a detachable connection, or an integral connection, may refer to a mechanical connection or an electrical connection, and may refer to a direct connection, an indirect connection via an intermediate medium, an internal communication between two devices, elements, or components. The specific meanings of these terms in the present application can be understood based on specific circumstances by those of ordinary skills in the art.

Terms "first" and "second" are primarily used for distinguishing different devices, elements, or components (which may be of the same or different types and structures), and are not intended to indicate or imply relative importance or quantity of the referenced devices, elements, or components. In the description of the embodiments of the present application, "a plurality" means two or more, unless otherwise specified.

The passivated contact solar cell in related art is a type of passivated contact cell in which a boron-diffused emitter is formed on the light-receiving surface, and a tunneling layer and a first doped polysilicon layer are formed on the back surface. For the passivated contact solar cells suitable for large-scale industrial production, although they exhibit a good high-temperature resistance characteristic, their photoelectric conversion efficiency has hit a bottleneck and is difficult to break through, remaining at approximately 25.1%. This is primarily because the emitter on the front surface of the passivated contact solar cell needs to balance the influences of Auger recombination and current transmission losses.

Since the emitter on the front surface of the passivated contact solar cell is a boron-diffused emitter, when current transmission losses are reduced by lowering the boron diffusion sheet resistance on the front surface, Auger recombination losses on the front surface can be significantly increased. When current transmission losses are reduced by increasing metal gridlines to decrease the resistance, more sunlight can be blocked by the metal gridlines, preventing sunlight from being absorbed by the silicon wafer, which still hinder the improvement of photoelectric conversion efficiency. Thus, it is difficult for current passivated contact solar cells to reduce both current transmission losses and recombination losses, thereby limiting further improvement of the photoelectric conversion efficiency of the passivated contact solar cells. Based on the analysis of the aforementioned technical problems, embodiments of the present application provide a solar cell, a preparation method thereof, and a photovoltaic module. By preparing a solar cell having a double-sided passivating contact structure and a back-surface PN junction, the photoelectric conversion efficiency of the solar cell is further increased, and the manufacturing process of such a solar cell is suitable for industrial application, rather than remains solely at the laboratory research stage with no potential for industrialization.

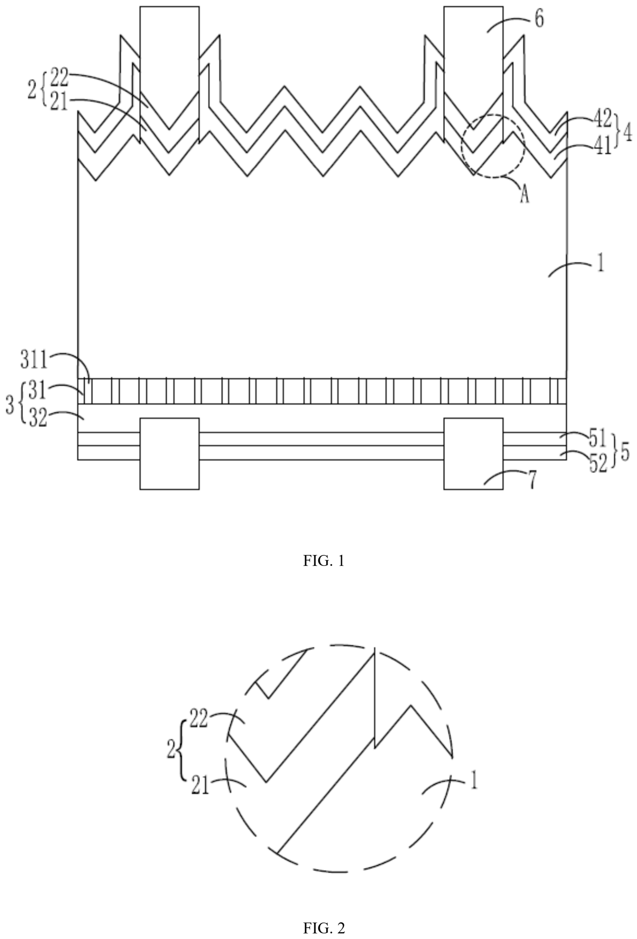

In a first aspect, embodiments of the present application provide a solar cell. As shown in FIG. 1, which is a schematic structural view of a solar cell according to an embodiment of the present application, the solar cell includes:
a substrate 1 having N-type conductivity;
a patterned first passivating contact structure 2 disposed on a light-receiving surface of the substrate 1, wherein the first passivating contact structure 2 includes a first dielectric layer 21 disposed adjacent to the substrate 1 and a first doped polysilicon layer 22 disposed away from the substrate 1, the first doped polysilicon layer 22 has N-type conductivity, and a thickness of the first dielectric layer 21 is less than or equal to 2 nm;
a second passivating contact structure 3 disposed on an entirety of a back surface of the substrate 1, wherein the second passivating contact structure 3 includes a second dielectric layer 31 disposed adjacent to the substrate 1 and a second doped polysilicon layer 32 disposed away from the substrate 1, and the second doped polysilicon layer 32 has a P-type conductivity different from the N-type conductivity to form a PN junction between the second doped polysilicon layer 32 and the substrate 1, and wherein a thickness of the second dielectric layer 31 is greater than 2 nm, the second dielectric layer 31 has a through-hole 311 that communicates the substrate 1 with the second doped polysilicon layer 32, and a doping concentration of the P-type conductive element in the second doped polysilicon layer is in a range from 5×10¹⁸ atoms/cm³ to 3×10²⁰ atoms/cm³;
a first function layer 4 disposed on the light-receiving surface of the substrate 1 and a surface of the first doped polysilicon layer 22 away from the substrate;
a second function layer 5 disposed on a surface of the second doped polysilicon layer 32 away from the substrate 1;
a first electrode 6 extending through the first function layer 4 and forming an ohmic contact with the first doped polysilicon layer 22, wherein a patterned region of the first passivating contact structure 2 is disposed corresponding to a patterned region of the first electrode 6; and
a second electrode 7 extending through the second function layer 5 and forming an ohmic contact with the second doped polysilicon layer 32.

The materials of the first dielectric layer and the second dielectric layer can include various dielectric materials, such as at least one of silicon oxide, magnesium fluoride, amorphous silicon, polycrystalline silicon, silicon carbide, silicon nitride, silicon oxynitride, aluminum oxide, or titanium oxide. Specifically, the dielectric layer may be composed of a silicon oxide layer containing silicon oxide. The silicon oxide layer has excellent passivation performance, which can minimize the recombination losses of minority carriers on the surface of the semiconductor substrate, and the silicon oxide layer is a film with excellent durability for subsequent high-temperature processes.

The thickness of the first dielectric layer 21 is less than or equal to 2 nm, preferably less than or equal to 1.5 nm. Under such a small thickness condition, electrons as carriers generated by light irradiation on the light-receiving surface can pass through the first dielectric layer 21 via a tunneling mechanism, achieving electron collection. It can be understood that the first dielectric layer 21 of this thickness can break and form some micro holes due to annealing operations during the manufacturing process. These micro holes can serve as electron transport channels, allowing electrons to be transported through both tunneling and direct conduction mechanisms to conduct electricity. Exemplarily, the thickness of the first dielectric layer 21 is in a range from 0.8 nm to 2.0 nm, including any point value within this range. For example, the thickness of the first dielectric layer 21 can be 0.8 nm, 0.9 nm, 1.0 nm, 1.2 nm, 1.5 nm, 1.6 nm, 1.8 nm, or 2.0 nm. Furthermore, the first dielectric layer 21 can also function as a diffusion barrier to prevent the dopant of the first doped polysilicon layer from diffusing into the semiconductor substrate, wherein the dopant of the first doped polysilicon layer refers to the N-type conductive element doped into the first doped polysilicon layer.

The thickness of the second dielectric layer 31 is greater than 2 nm. At this thickness, electrons can hardly pass through the film layer via a tunneling mechanism. A hole, which is larger in volume than an electron, is even less likely to pass through the film layer via a tunneling mechanism. Accordingly, the present application, by forming through-holes 311 in and extend through the second dielectric layer 31 along the thickness direction of the second dielectric layer 31, in combination with a P-type heavily doped polysilicon layer, enables hole transport on the back surface. Exemplarily, the thickness of the second dielectric layer can be 2.3 nm, 2.5 nm, 2.8 nm, 3.0 nm, 3.2 nm, 3.5 nm, 3.8 nm, or 4.0 nm. Furthermore, the second dielectric layer 31 can also function as a diffusion barrier to prevent the dopant of the second doped polysilicon layer from diffusing into the semiconductor substrate, wherein the dopant of the second doped polysilicon layer refers to the P-type conductive element doped into the second doped polysilicon layer.

The doping concentration of the P-type conductive element in the second doped polysilicon layer is in a range from 5×10¹⁸ atoms/cm³ to 3×10²⁰ atoms/cm³. Within this doping concentration range, the doping concentration of the P-type conductive element in the second doped polysilicon layer is relatively high, which qualifies as heavy doping. It can be found in the present application that when a relatively thick second dielectric layer with a thickness greater than 2 nm is disposed on the back surface, it can cooperate with the P-type second doped polysilicon layer at the above doping concentration to achieve excellent selection for holes, effectively addressing the issue that an electron with a small volume always has a higher passing-through probability than a hole with a large volume. Exemplarily, the doping concentration includes any point value within the above numerical range, for example, the doping concentration of the P-type conductive element in the second doped polysilicon layer can be 5×10¹⁸ atoms/cm³, 6×10¹⁸ atoms/cm³, 8×10¹⁸ atoms/cm³, 1×10¹⁹ atoms/cm³, 5×10¹⁹ atoms/cm³, 8×10¹⁹ atoms/cm³, 1×10²⁰ atoms/cm³, or 3×10²⁰ atoms/cm³.

The entire coverage with the second passivating contact structure 3 refers to that: unlike the patterned first passivating contact structure 2, the second passivating contact structure 3 covers the back surface of the N-type substrate 1, thereby forming a substantially complete film layer structure rather than a locally passivated patterned structure.

The patterned region of the first passivating contact structure is disposed corresponding to the patterned region of the first electrode, meaning that the patterned region of the first passivating contact structure and the patterned region of the first electrode correspond in position, with the same or similar width dimensions. For example, the widths of both patterns can be identical, or the width of the first passivating contact structure can be slightly greater than that of the first electrode, thereby ensuring that the first electrode, which is primarily made of metal, is only in contact with the first passivating contact structure and cannot be in contact with the silicon wafer, while also ensuring the alignment effect between the first electrode and the first passivating contact structure.

The embodiments of the present application provide a solar cell with composite multiple structures and functional characteristics that has a double-sided passivating contact structure, a PN junction structure having decoupled characteristic formed on the back surface, a local passivating contact structure formed on the light-receiving surface of the double-sided passivating contact structure and a passivating contact structure formed on an entirety of the back surface. Due to the above-mentioned multiple structures, the solar cell of the present application has both relatively low recombination losses and current transmission losses on the front surface, increasing the photoelectric conversion efficiency of the solar cell to 25.6% or more.

On the one hand, the solar cell of the embodiments of the present application has a first passivating contact structure 2 and a second passivating contact structure 3 on the light-receiving surface and the back surface of the substrate 1, respectively. Furthermore, the second doped polysilicon layer 32 of the second passivating contact structure 3 on the back surface has a conductivity type different from that of the substrate 1, which not only has the passivating contact function but also forms a PN junction relative to the substrate 1, thereby forming both a passivating contact structure and a PN junction structure, i.e., a passivating-contact PN junction structure, on the back surface of the solar cell. In this way, the passivating-contact PN junction structure can decouple the contact layer system from the light absorber, unlike the prior art, in which the boron-diffused PN junction is formed adjacent to the light-receiving surface of the substrate 1. Thus, the passivating-contact PN junction structure can effectively address the high Auger recombination issue in the light-receiving surface PN junction, thereby avoiding the contradiction between boron diffusion sheet resistance and Auger recombination losses in the light-receiving surface PN junction. It should be noted that when a first dielectric layer and a first doped polysilicon layer (e.g., a polysilicon layer doped with phosphorus element) are formed on the back surface of the substrate 1 in related art, the first dielectric layer and the first doped polysilicon layer can form a passivating contact structure. Nevertheless, strong electronic and chemical interactions still occur between this structure and the substrate 1, leading to band bending and diffusion. Consequently, the doped polysilicon layer in this structure is not decoupled from the substrate 1, and remains strongly associated with the substrate 1.

In addition to the advantage of decoupling, in the present application, since the passivating-contact PN junction structure is formed on the back surface, no shading occurs. Thus, the current transmission losses can be further reduced by increasing the number of metal gridlines on the back surface. Compared with forming the PN junction on the light-receiving surface, which requires considering various limitations such as the number and area of metal gridlines, in the embodiments of the present application, the passivating-contact PN junction structure is formed on the back surface, which not only has the advantage in reducing Auger recombination losses but also has the advantage of further reducing current transmission losses without affecting light absorption. That is, by disposing the passivating-contact PN junction structure on the back surface in the embodiments of this application, both the Auger recombination losses and current transmission losses can be reduced, thereby further improving the photoelectric conversion efficiency of the solar cell.

On the other hand, while the passivating-contact PN junction structure is formed on the back surface of the solar cell, a patterned first passivating contact structure 2 formed on the light-receiving surface is only located corresponding to the metallized region of the first electrode 6, according to the embodiments of the present application. That is, the first dielectric layer 21 and the first doped polysilicon layer 22 are disposed under the first electrode 6, but the first dielectric layer 21 and the first doped polysilicon layer 22 are not disposed under regions where no first electrode 6 is formed, leaving only the first function layer 4 (such as an anti-reflection layer and/or a passivating layer). Forming a local passivating contact structure on the light-receiving surface overcomes the high Auger recombination issue caused by boron diffusion doping, especially heavy doping, across the entire light-receiving surface, and reduces the metal-induced recombination caused by metallization on the light-receiving surface.

Moreover, since the light-receiving surface employs a local passivating contact structure, and other regions of the light-receiving surface can be provided with only conventional function layers (such as a passivation layer, an anti-reflection layer, etc.) , the first passivating contact structure 2 on the light-receiving surface can provide effective passivation effect, while mitigating parasitic absorption caused by the first doped polysilicon layer 22 of the first passivating contact structure 2, thereby improving the short-circuit current performance and optimizing the photoelectric conversion efficiency of the solar cell. As such, since a local passivating contact structure is formed on the light-receiving surface of the solar cell, the cell performance can be improved by reducing recombination losses and back surface resistance, thereby improving the photoelectric conversion efficiency of the solar cell. The passivating-contact PN junction structure is formed on the entire back surface of the solar cell, which not only can reduce the recombination losses on the light-receiving surface, but also can conduct electric current across the entire substrate 1, thereby reducing minority carrier transport losses at the front local metal contacts and improving the fill factor, further improving the photoelectric conversion efficiency of the solar cell.

More importantly, based on the above structural characteristics, the layers of the passivating contact structure of the light-receiving surface and the back surface, which are responsible for carrier transport and passivation, are controlled for their different thicknesses in the embodiments of the present application, and cooperates with the structural characteristics of N-type doping on the front surface and P-type heavily doping on the back surface to achieve effective transport of electrons on the front and back surfaces. For this solar cell with specific doping types, since the second doped polysilicon layer 32 on the back surface is a P-type heavily doped polysilicon layer, the second dielectric layer 31 located between the second doped polysilicon layer 32 and the N-type substrate 1 primarily functions to transport holes during the operation of the solar cell. In the present application, in views that the size of holes is larger than that of electrons, the holes are difficult to pass through the extremely thin film layer via the quantum tunneling effect as electrons do, the second dielectric layer 31 on the back surface is thickened and provided with through-holes 311, while the second doped polysilicon layer is heavily doped. In this way, due to the strong repulsion of the P-type second heavily doped polysilicon layer to electrons, holes can pass through smoothly while electrons are selectively repelled, thereby ensuring effective transport of hole by the through-holes 311. Meanwhile, since the thickness of the second dielectric layer 31 without through-holes 311 is greater than 2 nm, it is conducive to providing good passivation effect and mitigating the impact on passivation caused by the formation of through-holes 311.

The first doped polysilicon layer 22 on the light-receiving surface is the first doped polysilicon layer. The first dielectric layer 21 located between the first doped polysilicon layer and the N-type substrate 1 primarily functions to transport electrons during the operation of the solar cell. In the present application, the thickness of the first dielectric layer 21 is set to a relatively small value less than or equal to 2 nm, preferably to a relatively small value less than or equal to 1.5 nm, enabling electron tunneling via the quantum tunneling effect.

The layer structure of **the second passivating contact structure 3** is described below.

The second passivating contact structure 3 is disposed on the back surface of the substrate 1, which is not a patterned passivating contact structure but a passivating contact structure for entire surface coverage. The structure in the second passivating contact structure 3 used for carrier transport is the second dielectric layer 31. The second dielectric layer 31 has through-holes 311 extending therethrough, which can cooperate with the heavily doped second polysilicon layer 32, so that the through-holes 311 can selectively allow holes to pass through and block electrons.

The diameter of the through-hole 311 in the second dielectric layer 31 of the second passivating contact structure 3 can be in a range from 50 nm to 500 nm, and the number of the through-holes can be in a range from 1×10⁴/cm² to 1.6×10⁸/cm². The diameter of the through-hole 311 in the range from 50 nm to 500 nm includes any point value within this numerical range. For example, the diameter of the through-hole 311 can be 50 nm, 80 nm, 100 nm, 150 nm, 200 nm, 250 nm, 300 nm, 350 nm, 400 nm, 450 nm, or 500 nm. The number of through-holes 311 in the range from 1×10⁴ /cm² to 1.6×10⁸ /cm² includes any point value within this numerical range. For example, the number of through-hole 311 can be 1×10⁴ /cm², 5×10⁴ /cm², 1×10⁵ /cm², 5×10⁵ /cm², 1×10⁶ /cm², 5×10⁶ /cm², 1×10⁷ /cm², 5×10⁷ /cm², or 1×10⁸ /cm².

By controlling both the diameter and number of the through-holes 311 within the aforementioned ranges, a better balance between hole transport efficiency and passivation effect can be ensured. When the through-holes 311 has a too small diameter or there are too few through-holes 311, holes transportable directly through the through-holes 311 as channels declines. When the through-holes 311 has a too large diameter or there are too many through-holes 311, the passivation effect of the second dielectric layer 31 may be adversely affected.

In addition, the thickness of the second doped polysilicon layer 32 is in a range from 200 nm to 400 nm. A P-type conductive element doped in the second doped polysilicon layer 32 includes at least one of element boron, element indium, or element gallium, preferably element boron. The thickness of the second doped polysilicon layer 32 in the range from 200 nm to 400 nm includes any point value within this range. For example, the thickness of the second doped polysilicon layer 32 is 200 nm, 220 nm, 250 nm, 280 nm, 300 nm, 320 nm, 350 nm, or 400 nm.

The layer structure of the first passivating contact structure 2 is described below.

The width of the first passivating contact structure 2 is in a range from 20 µm to 110 µm. Since the first passivating contact structure 2 is located under the first electrode 6, and has the same patterned structure as the first electrode 6, the width of the first passivating contact structure matches to the first electrode 6, and slightly wider than that of the first electrode 6. Within this width range, the first passivating contact structure 2 can provide certain carrier transport and passivation effects, and can reduce the doping amount on the light-receiving surface of the substrate 1 by limiting the doping on the front surface to doping a gridline pattern, thereby better suppressing the Auger recombination caused by doping diffusion. It should be understood that the widths of both the first dielectric layer 21 and the first doped polysilicon layer 22 of the first passivating contact structure 2 fall within the above width range.

Further referring to FIG. 2, which is an enlarged schematic view of the structure at point A in FIG. 1, a region of the substrate 1 covered by the patterned first passivating contact structure 2 is 0.05 µm to 0.15 µm thicker than a region of the substrate 1 uncovered by the first passivating contact structure. That is, in the region uncovered by the patterned first passivating contact structure 2, the substrate 1 is relatively slightly thinner. This structural arrangement ensures that when preparing the patterned first passivating contact structure 2, the region where the first passivating contact structure 2 does not need to be retained can be completely etched away, without leaving any residue on the substrate 1, thereby preventing from absorbing light on the surface of the substrate and affecting the photoelectric conversion efficiency.

Further, the thickness of the first doped polysilicon layer 22 is in a range from 40 nm to 200 nm. The N-type conductive element doped in the first doped polysilicon layer 22 includes at least one of element phosphorus, element germanium, or element selenium, preferably element phosphorus. For example, the thickness of the first doped polysilicon layer 22 is 40 nm, 50 nm, 70 nm, 100 nm, 120 nm, 150 nm, 180 nm, or 200 nm. In the double-sided passivating contact structure of the present application, the second doped polysilicon layer on the back surface is thicker than the first doped polysilicon layer on the light-receiving surface, to achieve the same or similar sheet resistance. Taking the first doped polysilicon layer 22 doped with element phosphorus on the light-receiving surface and the second doped polysilicon layer 32 doped with element boron on the back surface as an example, the solid solubility of element phosphorus in the first doped polysilicon layer 22 is much higher than that of element boron in the second doped polysilicon layer 32. Therefore, the second doped polysilicon layer is thicker, which facilitates doping more element boron, enabling the sheet resistance of the back surface and the light-receiving surface to reach the same or similar levels.

The function layers and electrodes are described below.

On the light-receiving surface side of the substrate 1, the first function layer 4 includes a first passivation layer 41 disposed adjacent to the substrate 1 and a first anti-reflection layer 42 disposed away from the substrate 1. The thickness of the first passivation layer 41 can be in a range from 3 nm to 5 nm, for example, 3 nm, 4 nm, or 5 nm. The thickness of the first anti-reflection layer 42 can be in a range from 75 nm to 85 nm, for example, 75 nm, 78 nm, 80 nm, 82 nm, or 85 nm. The refractive index of the first anti-reflection layer 42 can be in a range from 1.95 to 2.00. The first passivation layer 41 can be a single layer or a composite of multiple sub-layers. The first passivation layer 41 is preferably an aluminum oxide layer and can be alternatively formed by compositing multiple aluminum oxide sub-layers. The first anti-reflection layer 42 can be a single layer or a composite of multiple sub-layers. For example, the first anti-reflection layer 42 can be a single silicon nitride layer, or can be formed by compositing multiple silicon nitride layers. Preferably, the first anti-reflection layer 42 is composed of a silicon nitride layer, a silicon oxynitride layer, and a silicon oxide layer disposed sequentially from inside to outside, i.e., from the direction adjacent to the substrate 1 to the direction away from the substrate 1.

On the back surface side of the substrate 1, the second function layer 5 includes a second passivation layer 51 disposed adjacent to the second doped polysilicon layer 32 and the second anti-reflection layer 52 disposed away from the second doped polysilicon layer 32. The thickness of the second passivation layer 51 can be in a range from 3 nm to 5 nm, for example, 3 nm, 4 nm, or 5 nm. The thickness of the second anti-reflection layer 52 can be in a range from 75 nm to 80 nm, for example, 75 nm, 76 nm, 77 nm, 78 nm, 79 nm, or 80 nm. The refractive index of the second anti-reflection layer 52 can be in a range from 2.10 to 2.15. The second passivation layer 51 can be a single layer or a composite of multiple sub-layers. For example, the second passivation layer 51 can be an aluminum oxide layer or can be obtained by compositing multiple aluminum oxide sub-layers. Disposing the second passivation layer 51 on the back surface side of the substrate 1 can passivate and protect the PN junction located on the back surface. The second anti-reflection layer 52 can be a single layer or a composite of multiple sub-layers. For example, the second anti-reflection layer 52 can be a single silicon nitride layer or can be obtained by compositing multiple silicon nitride layers.

In addition, since the PN junction in the embodiments of the present application is formed on the back surface side, more electrode gridlines can be disposed on this back surface side. The ratio of the quantity of the gridlines of the second electrode 7 to the quantity of the gridlines of the first electrode 6 can be in a range from 1.2:1 to 1.6:1. In this way, increasing the quantity of the gridlines on the back surface can further enhance current transmission capability without causing shading issues, thereby further improving the photoelectric conversion efficiency of the solar cell.

In a second aspect, embodiments of the present application provide a method for preparing the solar cell as described in the first aspect, including the following steps:
forming the passivating contact structure: forming a first passivating contact structure by disposing the first dielectric layer and a first doped amorphous silicon layer in sequence on a light-receiving surface of the substrate, and forming a second passivating contact structure by disposing the second dielectric layer and a second amorphous silicon layer in sequence on the back surface of the substrate, wherein a thickness of the first dielectric layer is less than or equal to 2 nm and a thickness of the second dielectric layer is greater than 2 nm;
annealing and patterning treatments: annealing the substrate on which the first passivating contact structure and/or the second passivating contact structure are formed to convert the first doped amorphous silicon layer into the first doped polysilicon layer, and/or to convert the second doped amorphous silicon layer into the second doped polysilicon layer, and patterning the first passivating contact structure to obtain a patterned first passivating contact structure; and
post-treatment: forming the first function layer on the light-receiving surface of the substrate and the patterned first doped polysilicon layer, forming the second function layer on the second doped polysilicon layer, fabricating the first electrode on the first function layer, and fabricating the second electrode on the second function layer.

It can be understood that, for the step of annealing and patterning treatments, the annealing treatment and the patterning treatment can be performed without limiting their sequence, the annealing treatment may precede the patterning treatment, or the patterning treatment may precede the annealing treatment.

Compared with existing solar cells with a PN junction on the front surface and a passivating contact structure on an entirety of the back surface, the solar cell prepared by the method in the embodiments of the present application has higher photoelectric conversion efficiency, open-circuit voltage, and fill factor. Compared with existing IBC (Interdigitated Back Contact) and HJT (Heterojunction Technology) solar cells, the solar cell of the present application has comparable photoelectric conversion efficiency and a shorter preparation process flow, and thus the solar cell in the embodiments of the present application has the advantages of low production costs and high photoelectric conversion efficiency for industrial applications.

In the preparation method, corresponding passivating contact structures are formed on the light-receiving surface and back surface of the substrate, with the passivating contact structure on the back surface having a conductivity type different from that of the substrate, thereby providing a film layer foundation for obtaining a solar cell having both double-sided passivating contact structures and multiple functional characteristics of local passivating contact on the front surface and a PN junction on the back surface. The first dielectric layer and the first doped amorphous silicon layer on the light-receiving surface are subjected to the annealing and patterning treatments. On the one hand, the recombination losses on the light-receiving surface are reduced through a local structure in which the first passivating contact structure is formed only under the first electrode by the patterning treatment. On the other hand, the doped amorphous silicon layer is converted into the doped polysilicon layer using the annealing treatment, thereby forming a solar cell having the following structural advantages: a double-sided passivating contact structure with local passivating contact on the front surface and a passivating contact on the entirety of the back surface, as well as a PN junction structure on the back surface.

In the preparation method according to the embodiments of the present application, the first passivating contact structure on the light-receiving surface can be fabricated before the second passivating contact structure on the back surface, or the second passivating contact structure on the back surface can be fabricated before the first passivating contact structure on the light-receiving surface.

In a first optional embodiment, the second passivating contact structure on the back surface is fabricated first, followed by the first passivating contact structure on the light-receiving surface. The step of forming the passivating contact structure includes:
alkali polishing: polishing the light-receiving surface and the back surface of the substrate using a first alkali agent;
depositing the second passivating contact structure: depositing the second dielectric layer and the second doped amorphous silicon layer in sequence on the back surface of the substrate;
texturing: removing the second doped amorphous silicon layer and the second dielectric layer that wrap around the light-receiving surface and edges using a first acid agent, and then texturing the light-receiving surface of the substrate using a second alkali agent; and
depositing the first passivating contact structure: depositing the first dielectric layer and the first doped amorphous silicon layer in sequence on the textured light-receiving surface.

In this embodiment, the second passivating contact structure on the back surface is deposited before the first passivating contact structure is deposited on the light-receiving surface. Unlike methods in which the substrate is first textured and then a PN junction is formed on the light-receiving surface of the substrate through boron diffusion, in this embodiment, the substrate is subjected to double-sided polishing using the first alkaline agent, the second dielectric layer and the second doped amorphous silicon layer are then deposited in sequence on the polished back surface of the substrate, and the light-receiving surface of the substrate is subsequently textured, followed by depositing the first dielectric layer and the first doped amorphous silicon layer in sequence on the textured light-receiving surface, thereby obtaining a film layer foundation having a textured structure and forming a double-sided passivating contact structure.

In the alkali polishing step, the first alkali agent includes an alkali metal hydroxide and an alkali polishing additive in a volume ratio ranging from 2:1 to 4:1. The temperature for alkali polishing is in a range from 70 °C to 90 °C, and the time for alkali polishing lasts 5 minutes (min) to 8 min. In the texturing step, the first acid agent is a hydrofluoric acid solution and a nitric acid solution in a volume ratio ranging from 1:2 to 1:5, the second alkali agent includes an alkali metal hydroxide and a texturing additive in a volume ratio ranging from 6:1 to 8:1. The temperature for texturing is in a range from 70 °C to 90 °C, and the texturing time lasts 5 minutes (min) to 8 min. The treatment of the substrate and the layers wrapping around the light-receiving surface with the above reagents can better achieve effects such as polishing, texturing and wrap-around removal.

The processes for depositing the first dielectric layer, the first doped amorphous silicon layer, the second dielectric layer, and the second doped amorphous silicon layer can be plasma enhanced chemical vapor deposition (PECVD), low pressure chemical vapor deposition (LPCVD), atomic layer deposition (ALD), or the like.

The steps for forming the passivating contact structure, the annealing treatment, and the patterning treatment through PECVD are described below.

The step of depositing the second passivating contact structure includes depositing the second dielectric layer, a back intrinsic layer, a back doped layer doped with the P-type conductive element, and a back mask layer in sequence on the alkali-polished back surface by PECVD;

The step of texturing includes removing the back mask layer, the back doped layer, the back intrinsic layer, and the second dielectric layer that wrap around the light-receiving surface and edges using a first acid agent, and then texturing the light-receiving surface using a second alkali agent.

The step of depositing the first passivating contact structure includes depositing the first dielectric layer, a front intrinsic layer and a front doped layer doped with the N-type conductive element in sequence on the textured light-receiving surface by PECVD.

The above three steps involve, after polishing both surfaces of the substrate, depositing respective layers in sequence on the back surface by PECVD, texturing and performing wrap-around removal on the light-receiving surface; and then depositing respective layers in sequence on the light-receiving surface. When depositing the first doped amorphous silicon layer on the light-receiving surface, depositing only the first dielectric layer and the N-type second doped amorphous silicon layer can achieve the same effect as that of depositing an additional back mask layer on the back surface, and meet the requirements for subsequent localized etching on the light-receiving surface. Therefore, omitting the deposition of a mask layer on the light-receiving surface helps reduce the cost for fabricating the first doped amorphous silicon layer on the light-receiving surface.

The deposition of the back mask layer on the back surface serves to prevent unnecessary damage to the above intrinsic layers and doped layers - caused by patterning operations such as etching, during the subsequent step of patterning the first passivating contact structure on the light-receiving surface. In this way, during the texturing, the back mask layer that wraps around the light-receiving surface can be removed using the first acidic agent, and other back layers that wrap around the light-receiving surface and edges can be then removed during the texturing.

Furthermore, the front doped layer can be a single layer or multiple layers. For example, the front doped layer includes a first front doped sublayer and a second front doped sublayer, each of the first front doped sublayer and the second front doped sublayer is doped with the N-type conductive element. Preferably, the N-type conductive element is element phosphorus. Compared with disposing only a single layer of the front doped layer, disposing the front doped sublayers with two or more layers allows for reducing the doping concentration of the N-type conductive element in each layer while ensuring the total doping concentration reaches a certain level, thereby lowering the probability of lattice distortion caused by high doping concentrations. Similarly, the back doped layer can be a single layer or multiple layers. For example, the back doped layer includes a first back doped sublayer and a second back doped sublayer, and each of the first back doped sublayer and the second back doped sublayer is doped with the P-type conductive element. Preferably, the P-type conductive element is element boron. When the back doped layer is structured in multiple layers, it achieves effects similar to those of the front doped layer in multiple layers.

Furthermore, the step of annealing and patterning treatments includes:
printing: printing a patterned alkali-resistant paste in a preset region of the front doped layer, and drying to cure the alkali-resistant paste;
cleaning: etching away the first doped amorphous silicon layer, the first dielectric layer, and a portion of the substrate uncovered in the preset region of the light-receiving surface using a third alkali agent, then etching away the alkali-resistant paste and the back mask layer on the back surface using a second acid agent, to form a patterned first dielectric layer and a patterned first doped amorphous silicon layer on the light-receiving surface of the substrate, wherein the substrate in the preset region is 0.5 µm to 1.5 µm thicker than the substrate uncovered in the preset region, and the second dielectric layer and the second doped amorphous silicon layer are formed on an entirety of the back surface of the substrate; and
annealing: annealing at 850°C to 1000°C in an inert atmosphere for 90 min to 150 min, to convert the first doped amorphous silicon layer into the first doped polysilicon layer, or to convert the second doped amorphous silicon layer into the second doped polysilicon layer, and to form a PN junction between the substrate and the second doped polysilicon layer.

The alkali-resistant paste can be those commonly used in the art, or may comprise the following components, in parts by weight: 80 parts to 95 parts of an acrylic-modified epoxy resin, 8 parts to 15 parts of a filler, 2 parts to 5 parts of a leveling agent, and 2 parts to 5 parts of a defoaming agent.

In this embodiment, a patterned alkali-resistant paste is printed and cured in a preset region of the first doped amorphous silicon layer of the light-receiving surface, to protect the first doped amorphous silicon layer and first dielectric layer in the preset region using the resistance of alkali-resistant paste to alkaline etching. In this way, since no front mask layer is deposited on the first doped amorphous silicon layer, and only the patterned alkali-resistant paste serves as a protective layer, there is no need to treat the front mask layer using reagents. The first doped amorphous silicon layer and the first dielectric layer outside the preset region can be etched away directly using a third alkaline agent, retaining only the first doped amorphous silicon layer and the first dielectric layer in the preset region. Based on this, a second acidic agent has dual effects: it removes not only the alkali-resistant paste, but also the back mask layer on the back surface. This results in the local first dielectric layer and first doped amorphous silicon layer formed on the light-receiving surface and corresponding only to the region under the first electrode, while the second dielectric layer and the second doped polysilicon layer are formed on an entirety of the back surface.

Furthermore, when etching using the third alkaline agent, a portion of the substrate is removed, so that the etched portion of the substrate is 0.5 µm to 1.5 µm lower than the substrate in the preset region, it can ensure complete removal of the unwanted first doped amorphous silicon layer and first dielectric layer, thereby preventing any residual of the first passivating contact structure on the substrate surface and light absorption. Additionally, this etching step also functions as a secondary texturing, forming a textured structure with more uniform morphology and lower reflectivity on the surface of the etched portion of the substrate. This guarantees that only the first doped amorphous silicon layer and first dielectric layer in the preset region are protected, ultimately forming an effective, patterned first passivating contact structure.

It can be seen that, the approach for forming the double-sided passivating contact structure, which involves forming the second passivating contact structure by alkaline polishing and PECVD and then forming the first passivating contact structure by texturing and PECVD, achieves the dual effects of texturing and the removal of front wrapping-around in a single step of texturing, thereby saving process steps. Furthermore, on this basis, the first passivating contact structure can be deposited without forming a front mask layer, and the patterning of the front first passivating contact structure can be achieved via subsequently printing an alkali-resistant paste, etching, cleaning, and the like, which not only omits the steps of fabricating a front mask layer, but also achieves the dual effects of removal of the alkali-resistant paste and the back mask layer in a single treatment process of etching using the second acid agent in the cleaning step. Therefore, through the close coordination among different steps, the above preparation method of the present application can optimize and omit multiple process steps, simplify the process flow, and lower production costs.

The preset region refers to a region where the first electrode is subsequently printed, i.e., a metallization region, which is a region with relatively poor light transmittance in the solar cell. The first dielectric layer and the first doped polysilicon layer are deposited only in the preset region, which enhances light absorption on the front surface and helps reduce recombination losses. The printing can, for example, be screen printing or laser printing. The temperature for annealing is in a range from 850°C to 1000 °C, including any point value within this range, such as 850 °C, 870 °C, 900 °C, 920 °C, 940 °C, 950 °C, 980 °C, or 1000 °C. The time for annealing lasts 90 min to 150 min, including any point value within this range, such as 90 min, 100 min, 110 min, 120 min, 130 min, 140 min, or 150 min.

In the printing step, a width of the printed patterned alkali-resistant paste is in a range from 20 µm to 110 µm, and after printing, drying is performed at a temperature in a range from 150 °C to 250 °C for a time period in a range from 8 seconds to 12 seconds. In the cleaning step, the third alkali agent includes an alkali metal hydroxide and a texturing additive in a volume ratio from 1:1 to 3:1, and the etching using the third alkali agent is performed at a temperature from 70°C to 90°C for 1 min to 3 min. In the cleaning step, the second acid agent is a hydrofluoric acid solution with a volume percentage of 4% to 6%.

Preferably, in the cleaning step, the first dielectric layer and the first doped amorphous silicon layer that are not covered in the preset region on the light-receiving surface are etched away in a tank-type texturing machine using the third alkaline agent; then the substrate is transferred into an acid-containing tank and the alkali-resistant paste and the back mask layer on the back surface are etched away using a second acid agent, so that the first dielectric layer and the first doped amorphous silicon layer in the preset region are disposed in sequence on the light-receiving surface of the substrate, while the second dielectric layer and the second doped amorphous silicon layer are disposed in sequence on the entire back surface of the substrate. Since only the tank-type texturing machine, rather than a chain-type machine, is required in the cleaning step, one process step is omitted, thereby lowering equipment and material cost.

The steps for forming the passivating contact structure using LPCVD, the annealing treatment, and the patterning treatment are described below.

The step of depositing the second passivating contact structure includes: forming the second dielectric layer on the alkali-polished back surface through thermal oxidation process, forming a back intrinsic amorphous silicon layer through LPCVD, and then doping the back intrinsic amorphous silicon layer with a P-type conductive element through a diffusion process, to convert the back intrinsic amorphous silicon layer into the second doped polysilicon layer and to form a PN junction between the second doped polysilicon layer and the substrate.

The texturing step includes removing the second doped polysilicon layer and the second dielectric layer that wrap around the light-receiving surface and edges using the first acid agent, then texturing the light-receiving surface using the second alkali agent.

The step of depositing the first passivating contact structure includes depositing the first dielectric layer, a front intrinsic layer, a front doped layer doped with the N-type conductive element, and a front mask layer in sequence on the textured light-receiving surface by PECVD.

It can be understood that after forming the intrinsic amorphous silicon layer on the back surface through LPCVD and subjecting to a diffusion process, in addition to converting the back intrinsic amorphous silicon layer into the second doped polysilicon layer, a silicon glass having a P-type conductive element is formed on a surface of the second doped polysilicon layer. Taking boron as an example of the P-type conductive element, after the boron diffusion process, a boron-doped second doped polysilicon layer on the back surface and a borosilicate glass layer on a surface of the boron-doped second doped polysilicon layer are formed. This borosilicate glass layer functions equivalently as a back mask layer, and is capable of protecting the second doped polysilicon layer.

Furthermore, the step of annealing and patterning treatments includes:
annealing: annealing at 850°C to 950°C in an inert atmosphere for 90 min to 150 min, to convert the first doped amorphous silicon layer into the first doped polysilicon layer;
printing: printing a patterned acid-resistant paste in a preset region of the front doped layer, and drying to cure the acid-resistant paste;
cleaning: etching away the front mask layer uncovered in the preset region of the light-receiving surface using a third acid agent, then etching away the first doped polysilicon layer, and the first dielectric layer that are not covered in the preset region of the light-receiving surface and the acid-resistant paste using a fourth alkali agent, and removing the remaining front mask layer using a fourth acid agent, to form a patterned first dielectric layer and a patterned first doped amorphous silicon layer on the light-receiving surface of the substrate and a front second dielectric layer and a second doped polysilicon layer on a front of the back surface of the substrate.

The acid-resistant paste can be those commonly used in the art, or may comprise the following components, in parts by weight: 80 parts to 95 parts of a polyester resin, 8 parts to 15 parts of a filler, 2 parts to 5 parts of a leveling agent, and 2 parts to 5 parts of a defoaming agent.

In the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds. In the cleaning step, the third acid agent is a hydrofluoric acid solution with a volume percentage of 4% to 6%. The fourth alkali agent includes an alkali metal hydroxide and a texturing additive in a volume ratio from 1:1 to 3:1, and the etching using the fourth alkali agent is performed at a temperature from 70 °C to 90 °C for 1 min to 3 min. In the cleaning step, the fourth acid agent is a hydrofluoric acid solution with a volume percentage of 4% to 6%.

It can be understood that, in the above cleaning step, in addition to removing the remaining front mask layer using fourth acid agent, when a silicon glass is present on the second doped polysilicon layer functioning as a back mask layer, the fourth acid agent can also remove this back mask layer.

In a second optional embodiment, the first passivating contact structure is formed on the light-receiving surface and then the second passivating contact structure is formed on the back surface. The step of forming the passivating contact structure includes:
texturing: texturing the substrate using a fifth alkali agent;
depositing the first passivating contact structure: depositing the first dielectric layer and the first doped amorphous silicon layer in sequence on the textured light-receiving surface;
alkali polishing: removing a portion of the first doped amorphous silicon layer wrapping around the back surface using a fifth acid agent, then polishing the back surface of the substrate using a sixth alkali agent, and removing the remaining first doped amorphous silicon layer and the first dielectric layer that wrap around the back surface and edges; and
depositing the second passivating contact structure: depositing the second dielectric layer, and the second doped amorphous silicon layer in sequence on the back surface.

In this embodiment, the light-receiving surface of the substrate is textured to form a textured structure, the first dielectric layer and the first doped amorphous silicon layer are deposited in sequence on the light-receiving surface of the substrate having the textured structure, then the back surface of the substrate is subjected to alkali polishing to achieve the dual effects of polishing the back surface and removing material that wraps around the back surface in this single operation of alkali polishing, and finally, the second dielectric layer and the first doped amorphous silicon layer are formed in sequence on the polished back surface.

In the texturing step, the fifth alkali agent includes an alkali metal hydroxide and a texturing additive in a volume ratio ranging from 6:1 to 8:1. The temperature for texturing is in a range from 70 °C to 90 °C, and the time for texturing lasts 5 minutes (min) to 8 min. In the alkali polishing step, the fifth acid agent is a hydrofluoric acid solution with a volume percentage of 4% to 6%, and the sixth alkali agent includes an alkali metal hydroxide and an alkali polishing additive in a volume ratio ranging from 2:1 to 4:1. The temperature for alkali polishing is in a range from 70 °C to 90 °C, and the time for alkali polishing lasts 5 minutes (min) to 8 min. The treatment of the substrate and wrapping-around layers with the above reagents can better achieve effects such as texturing, polishing, and wrap-around removal.

The processes for depositing the first dielectric layer, the first doped amorphous silicon layer, the second dielectric layer, and the second doped amorphous silicon layer can be plasma enhanced chemical vapor deposition (PECVD), low pressure chemical vapor deposition (LPCVD), atomic layer deposition (ALD), or the like.

The steps for forming the passivating contact structure through PECVD, the annealing treatment, and the patterning treatment are described below.

The step of depositing the first passivating contact structure includes depositing the first dielectric layer, a front intrinsic layer, a back doped layer doped with the N-type conductive element, and a front mask layer in sequence on the textured light-receiving surface through PECVD.

The step of alkali polishing includes removing the front mask layer wrapping around the back surface using the fifth acid agent, then polishing the back surface of the substrate using the sixth alkali agent, and removing the front doped layer, the front intrinsic layer, and the first dielectric layer that wrap around the back surface and edges.

Depositing the second passivating contact structure includes depositing the second dielectric layer, a back intrinsic layer, a back doped layer doped with the P-type conductive element, and a back mask layer in sequence on the alkali-polished back surface by PECVD.

Furthermore, the step of annealing and patterning treatments includes:
annealing: annealing the substrate on which the first and second passivating contact structures are formed, at 850°C to 1000°C in an inert atmosphere for 90 min to 150 min;
printing: printing a patterned acid-resistant paste in the preset region of the first doped amorphous silicon layer, and drying to cure the acid-resistant paste; and
cleaning: etching away the front mask layer on the light-receiving surface using a sixth acid agent, then etching away the acid-resistant paste, and the first dielectric layer and the first doped amorphous silicon layer that are not covered in the preset region of the light-receiving surface using a seventh alkali agent, and removing the front mask layer and the back mask layer using a seventh acid agent.

The temperature for annealing is in a range from 850°C to 1000 °C, including any point value within this range, such as 850 °C, 870 °C, 900 °C, 920 °C, 940 °C, 950 °C, 980 °C, or 1000 °C. The time for annealing lasts 90 min to 150 min, including any point value within this range, such as 90 min, 100 min, 110 min, 120 min, 130 min, 140 min, or 150 min.

Furthermore, in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds. In the cleaning step, the sixth acid agent is a hydrofluoric acid solution with a volume percentage of 4% to 6%. The seventh alkali agent includes an alkali metal hydroxide and a texturing additive in a volume ratio from 1:1 to 3:1, and the etching using the seventh alkali agent is performed at a temperature from 70°C to 90 °C for 1 min to 3 min. The seventh acid agent is a hydrofluoric acid solution with a volume percentage of 4% to 6%.

The post-treatment step is described below.

The post-treatment step includes:
depositing the first passivation layer and the second passivation layer on the light-receiving surface and the back surface by ALD, respectively;
depositing the first anti-reflection layer on the first passivation layer and the second anti-reflection layer on the second passivation layer by PECVD;
printing a first electrode on the front surface and forming an ohmic contact between the first electrode and the first doped polysilicon layer located in the preset region; and
printing a second electrode on the back surface and forming an ohmic contact between the second electrode and the second doped polysilicon layer.

The first electrode is printed on the front surface, for example, by screen-printing silver paste on the front surface to form an ohmic contact with the first doped polysilicon layer on the front surface. Similarly, the second electrode is printed on the back surface, for example, by screen-printing silver paste on the back surface to form an ohmic contact with the second doped polysilicon layer on the back surface.

Furthermore, in the ALD process, the depositing is performed at a temperature in a range from 200 °C to 280 °C, and the first passivation layer and the second passivation layer are deposited to a thickness from 3 nm to 5 nm, respectively.

In a third aspect, embodiments of the present application provide a photovoltaic module, including the solar cell as described in the first aspect, or the solar cell prepared by the preparation method as described in the second aspect. By connecting multiple solar cells as described above in series and/or parallel and encapsulating the solar cells, a photovoltaic module can be formed.

The solar cells prepared in the present application and their performance will be further explained below in conjunction with examples, accompanying drawings, and testing data.

### Example 1

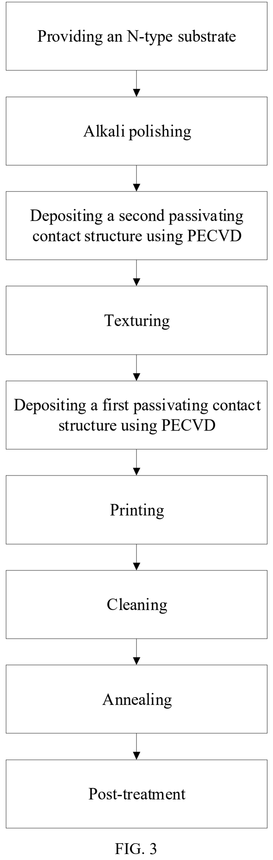

This example provides a solar cell. As shown in FIG. 3, which is a flowchart for preparing the solar cell of this example, the solar cell was prepared by the following method:

Providing an N-type substrate: An N-type 182-size M10 silicon wafer was used as the N-type substrate, with a resistivity ranging from 1.0 Ω·cm to 3.5 Ω·cm and a minority carrier lifetime of >1 ms. The N-type substrate has a light-receiving surface and a back surface disposed opposite to each other, with the light-receiving surface serving as a light-incident surface.

Alkali polishing: Both surfaces of the N-type substrate were polished at a temperature of 80 °C for 7 minutes using sodium hydroxide and alkali polishing additive BP31 in a volume ratio of 3:1 in a tank-type machine;

Depositing a second passivating contact structure using PECVD: Films were deposited on the back surface of the N-type substrate in a tubular PECVD apparatus under a pressure ranging from 2500 mTorr to 3500 mTorr at a temperature ranging from 330 °C to 450 °C. The deposited films were used for forming a second dielectric layer and second doped amorphous silicon layer.

Layer 1: Using PECVD, 8 standard liter per minute (SLM) to 15 SLM of N₂O was introduced to deposit a second dielectric layer of SiOₓ, where the deposition time period was 350 seconds (s) to 600 s.

Layer 2: Using PECVD, SiH₄ and H₂ in a volume ratio of 1:2.5 were introduced to deposit a back intrinsic layer as an amorphous film with a thickness of 5 nm to 40 nm, where the deposition time period was 40 s to 90 s.

Layer 3: Using PECVD, SiH₄, trimethyl-boron (TMB), and H₂ in a volume ratio of 1:0.3:2.5 were introduced to deposit a first back doped layer doped with element boron as an amorphous silicon film with a thickness of 10 nm to 80 nm, where the deposition time period was 80 s to 300 s.

Layer 4: Using PECVD, SiH₄, TMB, and H₂ in a volume ratio of 1: 0.6: 2.5 were introduced to deposit a second back doped layer doped with element boron as an amorphous silicon film with a thickness of 60 nm to 180 nm, where a deposition time period was 500 s to 700 s.

Layer 5: Using PECVD, SiH₄, NH₃, and N₂O in a volume ratio of 1:4:7 were introduced to deposit a silicon oxynitride film as a back mask layer with a thickness of 5 nm to 40 nm, where a deposition time period was 60 s to 200 s.

Texturing: Using a chain-type machine, the back mask layer, the second back doped layer, the first back doped layer, the back intrinsic layer, and the second dielectric layer that wrap around the light-receiving surface and edges were removed with a hydrofluoric acid solution and a nitric acid solution in a volume ratio ranging from 1:2 to 1:5. Then the N-type substrate was transferred to a tank-type alkali polishing machine, and the light-receiving surface of the N-type substrate was textured using sodium hydroxide and texturing additive TS40 in a volume ratio of 7:1 at a temperature of 80 °C for 7 minutes.

Depositing a first passivating contact structure using PECVD: Films were deposited in sequence on the textured light-receiving surface in a tubular PECVD apparatus under a pressure ranging from 2500 mTorr to 3500 mTorr at a temperature ranging from 350 °C to 450 °C. The deposited films were used for forming a first dielectric layer and a first doped amorphous silicon layer.

Layer 1: Using PECVD, 8 SLM to 15 SLM of N₂O was introduced to deposit a first dielectric layer of SiOₓ with a thickness of 1.5 nm, where the deposition time period was 140 seconds (s).

Layer 2: Using PECVD, SiH₄ and H₂ in a volume ratio of 1:2.5 were introduced to deposit a front intrinsic layer as an amorphous film with a thickness of 5 nm to 40 nm, where the deposition time period was 40 s to 90 s.

Layer 3: Using PECVD, SiH₄, PH₃, and H₂ in a volume ratio of 1:0.4:2.5 were introduced to deposit a first front doped layer doped with element phosphorus as an amorphous silicon film with a thickness of 5 nm to 40 nm, where the deposition time period was 40 s to 90 s.

Layer 4: Using PECVD, SiH₄, PH₃, and H₂ in a volume ratio of 1:0.8:2.5 were introduced to deposit a second front doped layer doped with element phosphorus as an amorphous silicon film with a thickness of 20 nm to 80 nm, where a deposition time period was 250 s to 350 s.

Printing: A patterned alkali-resistant paste was screen printed in the preset region of a surface of the front doped layer. The resulting pattern matches to or is similar or identical to the pattern of the first electrode to be screen printed, and the width of the printed alkali-resistant paste is in a range from 20 µm to 110 µm, slightly wider than the width of the first electrode pattern to be screen-printed. After printing, the printed alkali-resistant paste was dried at 150 °C to 250 °C for 10 s. The alkali-resistant paste can protect the first dielectric layer and the first doped amorphous silicon layer, i.e., the amorphous silicon film layers such as the front intrinsic layer, the first front doped layer, and the second front doped layer under the alkali-resistant paste. The preset region corresponded to the region where the metal electrode was to be disposed in the solar cell.

Cleaning: The substrate was transferred into a tank-type texturing machine, the first dielectric layer, the first doped amorphous silicon layer, and a portion of the N-type substrate that were uncovered in the preset region on the light-receiving surface were etched away at a temperature of 80 °C for an etching time period of 2 minutes using sodium hydroxide and texturing additive TS40 in a volume ratio of 2:1. Then the substrate was transferred into an acid tank, the alkali-resistant paste, and the back mask layer on the back surface were etched away using a hydrofluoric acid solution with a volume percentage of 5%, with the second doped amorphous silicon layer retained, so that the substrate within the preset region is 1 µm thicker than the substrate not covered in the preset region. After cleaning, a first dielectric layer and a first doped amorphous silicon layer within the preset region were formed on the light-receiving surface of the N-type substrate in sequence, while a second dielectric layer and a second doped amorphous silicon layer were formed on the entire back surface of the N-type substrate in sequence.

Annealing: In a tubular annealing furnace, annealing was conducted at 850 °C for 120 minutes in an atmosphere of 10 SLM nitrogen gas, so that the first doped amorphous silicon layer was transformed into an first doped polysilicon layer, the second doped amorphous silicon layer was transformed into a second doped polysilicon layer, the first dielectric layer and the first doped polysilicon layer constituted the first passivating contact structure, the second dielectric layer and the second doped polysilicon layer constituted the second passivating contact structure, and a PN junction was formed between the N-type substrate and the P-type second doped polysilicon layer since the second doped polysilicon layer was doped with a P-type conductive element.

### Post-treatment:

Using atomic layer deposition (ALD), aluminum oxide layers were deposited as a first passivation layer and a second passivation layer on the light-receiving surface and the back surface, respectively, at a temperature of 200 °C to 280 °C, with a thickness of 3 nm to 5 nm.

Using PECVD, a silicon nitride layer, a silicon oxynitride layer, and a silicon oxide layer, as a first anti-reflection layer, were deposited in sequence on the first passivation layer. The total thickness of the first anti-reflection layer was in a range from 75 nm to 85 nm, with a refractive index of 1.95 to 2.00. Using PECVD, silicon nitride, as a second anti-reflection layer, was deposited on the second passivation layer. The second anti-reflection layer had a thickness of 75 nm to 80 nm and a refractive index of 2.10 to 2.15.

Screen printing: A silver paste was printed on the back surface and on the light-receiving surface sequentially, and then sintered at 840 °C to form the second electrode and the first electrode, respectively, wherein the first electrode extended through the first anti-reflection layer and the first passivation layer and formed an ohmic contact with the first doped polysilicon layer located in the preset region, and the second electrode extended through the second anti-reflection layer and the second passivation layer and formed an ohmic contact with the second doped polysilicon layer located in the preset region. The cell was subjected to light injection at a temperature of 700 °C. The number of gridlines of the second electrode was 1.6 times that of gridlines of the first electrode.

In the solar cell of this example, the parameters of the passivating contact structure, including layer thickness, doping concentration, through-hole parameters, etc., are detailed in Table 1 below.

### Example 2

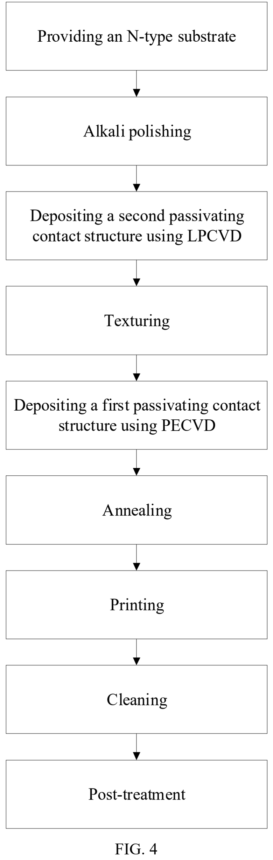

This example provides a solar cell. As shown in FIG. 4, which is a flowchart for preparing the solar cell of this example, the solar cell was prepared by the following method:

Providing an N-type substrate: An N-type 182-size M10 silicon wafer was used as the N-type substrate, with a resistivity ranging from 1.0 Ω·cm to 3.5 Ω·cm and a minority carrier lifetime of >1 ms. The N-type substrate has a light-receiving surface and a back surface disposed opposite to each other, with the light-receiving surface serving as a light-incident surface.

Alkali polishing: Both surfaces of the N-type substrate was polished at a temperature of 80 °C for 7 minutes using sodium hydroxide and alkali polishing additive BP31 in a volume ratio of 3:1 in a tank-type machine;

Depositing a second passivating contact structure using LPCVD: Films were deposited on the back surface of the N-type substrate in a tubular LPCVD apparatus under near-vacuum conditions.

Layer 1: Using high-temperature thermal oxidation process, O₂ was introduced at a temperature of 590 °C to 630 °C to deposit a second dielectric layer, where the deposition time period was 2500 s to 4000 s.

Layer 2: Using LPCVD, the temperature was cooled to 540 °C to 580 °C and SiH₄ was introduced to deposit a back intrinsic amorphous silicon layer, where the deposition time period was 4500 s to 6000 s and the back intrinsic amorphous silicon layer has a thickness of 250 nm to 350 nm.

Layer 3: Using a tubular diffusion furnace, boron diffusion was carried out at a temperature of 850 °C to 950 °C for 90 minutes to 150 minutes in a gas atmosphere consisting of 2 SLM to 10 SLM of nitrogen, 100 sccm to 1000 sccm of oxygen, and 50 sccm to 200 sccm of boron trichloride, so that the back intrinsic amorphous silicon layer deposited in the previous step was doped with boron to form a boron-doped polysilicon layer, i.e., the P-type second doped polysilicon layer, and to form a PN junction between the N-type substrate and the second doped polysilicon layer.

Texturing: the second doped polysilicon layer and the second dielectric layer that wrap around the light-receiving surface and edges were removed with a hydrofluoric acid solution and a nitric acid solution in a volume ratio ranging from 1:2 to 1:5. Then the N-type substrate was transferred to a tank-type alkali polishing machine, and the front surface of the N-type substrate was textured using sodium hydroxide and texturing additive TS40 in a volume ratio of 7:1 at a temperature of 80 °C for 7 minutes.

Depositing a first passivating contact structure using PECVD: four films were deposited in sequence on the textured light-receiving surface in a tubular PECVD apparatus under a pressure ranging from 2500 mTorr to 3500 mTorr at a temperature ranging from 350 °C to 450 °C, to form a first dielectric layer and a first doped amorphous silicon layer.

Layer 1: Using PECVD, 8 SLM to 15 SLM of N₂O was introduced to deposit a first dielectric layer of SiOₓ with a thickness of 1.5 nm, where the deposition time period was 140 seconds (s).

Layer 2: Using PECVD, SiH₄ and H₂ in a volume ratio of 1:2.5 were introduced to deposit a front intrinsic layer as an amorphous film with a thickness of 5 nm to 40 nm, where the deposition time period was 40 s to 90 s.

Layer 3: Using PECVD, SiH₄, PH₃, and H₂ in a volume ratio of 1:0.4:2.5 were introduced to deposit a first front doped layer doped with element phosphorus as an amorphous silicon film with a thickness of 5 nm to 40 nm, where the deposition time period was 40 s to 90 s.

Layer 4: Using PECVD, SiH₄, PH₃, and H₂ in a volume ratio of 1:0.8:2.5 were introduced to deposit a second front doped layer doped with element phosphorus as an amorphous silicon film with a thickness of 20 nm to 80 nm, where a deposition time period was 250 s to 350 s.

Layer 5: Using PECVD, SiH₄ and N₂O in a volume ratio of 1:8 were introduced to deposit a silicon oxynitride layer as a front mask layer with a thickness of 5 nm to 20 nm, where the deposition time period was 20 s to 100 s.

Annealing: In a tubular annealing furnace, the silicon wafer was annealed for 120 minutes at a temperature of 850 °C to 950 °C in a gas atmosphere of 2 SLM to 10 SLM of nitrogen, to transform the crystal structures of the deposited amorphous silicon films, forming a phosphorus-doped polysilicon layer.

Printing: A patterned acid-resistant paste was screen printed in the preset region of a surface of the front mask layer. The resulting pattern is similar or identical to the pattern of the first electrode to be screen printed, and the width of the printed acid-resistant paste is in a range from 20 µm to 110 µm, slightly wider than the width of the first electrode pattern to be screen-printed. After printing, the printed acid-resistant paste was dried at 150 °C to 250 °C for 10 s. The acid-resistant paste can protect the first dielectric layer and the first doped amorphous silicon layer, i.e., the amorphous silicon films such as the front intrinsic layer, the first front doped layer, and the second front doped layer under the alkali-resistant paste. The preset region corresponded to the region where the first electrode was to be disposed in the solar cell.

Cleaning: Using a chain-type apparatus, the front mask layer not covered in the preset region of the light-receiving surface was removed using a hydrofluoric acid solution with a volume percentage of 5%. Then the N-type substrate was transferred into a tank-type texturing machine by a mechanical arm, the first dielectric layer, the first doped amorphous silicon layer, and the acid-resistant paste that were uncovered in the preset region on the light-receiving surface were etched away at a temperature of 80 °C for 2 minutes using sodium hydroxide and texturing additive TS40 in a volume ratio of 2:1. Then the N-type substrate was transferred into an acid tank, the remaining front mask layer and the borosilicate glass formed on the second doped polysilicon layer caused by boron diffusion on the back surface were etched away using a hydrofluoric acid solution with a volume percentage of 5%, with the P-type doped amorphous silicon layer on the back surface retained, so that a first dielectric layer and a N-type doped amorphous silicon layer in the preset region were formed on the light-receiving surface of the N-type substrate in sequence, while a second dielectric layer and a P-type doped amorphous silicon layer were formed on the entire back surface of the N-type substrate in sequence.

### Post-treatment:

Using atomic layer deposition (ALD), aluminum oxide layers were deposited, as a first passivation layer and a second passivation layer on the light-receiving surface and back surface, respectively, at a temperature of 200 °C to 280 °C, with a thickness of 3 nm to 5 nm.

Using PECVD, a silicon nitride layer, a silicon oxynitride layer, and a silicon oxide layer, as a first anti-reflection layer, were deposited in sequence on the first passivation layer. The total thickness of the first anti-reflection layer was in a range from 75 nm to 85 nm, with a refractive index of 1.95 to 2.00. Using PECVD, silicon nitride, as a second anti-reflection layer, was deposited on the second passivation layer. The second anti-reflection layer had a thickness of 75 nm to 80 nm and a refractive index of 2.10 to 2.15.

Screen printing: A silver paste was printed on the back surface and on the light-receiving surface sequentially, and then sintered at 840 °C to form the second electrode and the first electrode, respectively, wherein the first electrode extended through the first anti-reflection layer and the first passivation layer and formed an ohmic contact with the first doped polysilicon layer located in the preset region, and the second electrode extended through the second anti-reflection layer and the second passivation layer and formed an ohmic contact with the second doped polysilicon layer located in the preset region. The cell was subjected to light injection at a temperature of 700 °C. The number of gridlines of the second electrode was 1.2 times that of gridlines of the first electrode.

In the solar cell of this example, the parameters of the passivating contact structure, including layer thickness, doping concentration, through-hole parameters, etc., are detailed in Table 1 below.

### Example 3

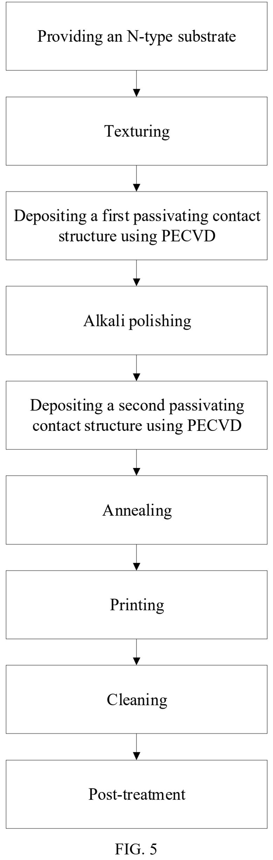

This example provides a solar cell. As shown in FIG. 5, which is a flowchart for preparing the solar cell of this example, the solar cell was prepared by the following method:

Providing an N-type substrate: An N-type 182-size M10 silicon wafer was used as the N-type substrate, with a resistivity ranging from 1.0 Ω·cm to 3.5 Ω·cm and a minority carrier lifetime of >1 ms. The N-type substrate has a light-receiving surface and a back surface disposed opposite to each other, with the light-receiving surface serving as a light-incident surface.

Texturing: In a tank-type apparatus, the light-receiving surface of the N-type substrate was textured using sodium hydroxide and texturing additive TS40 in a volume ratio of 7:1 at a temperature of 80 °C for 7 minutes, during which the thickness reduction was controlled to 5 µm.

Depositing a first passivating contact structure using PECVD: Films were deposited on the textured light-receiving surface in a tubular PECVD apparatus under a pressure ranging from 2500 mTorr to 3500 mTorr at a temperature ranging from 350 °C to 450 °C.

Layer 1: Using PECVD, 8 standard liter per minute (SLM) to 15 SLM of N₂O was introduced to deposit a first dielectric layer of SiOₓ with a thickness of 1.5 nm, where the deposition time period was 140 seconds (s).

Layer 2: Using PECVD, SiH₄ and H₂ in a volume ratio of 1:2.5 were introduced to deposit a front intrinsic layer as an amorphous film with a thickness of 5 nm to 40 nm, where the deposition time period was 40 s to 90 s.

Layer 3: Using PECVD, SiH₄, PH₃, and H₂ in a volume ratio of 1:0.4:2.5 were introduced to deposit a first front doped layer doped with element phosphorus as an amorphous silicon film with a thickness of 5 nm to 40 nm, where the deposition time period was 40 s to 90 s.

Layer 4: Using PECVD, SiH₄, PH₃, and H₂ in a volume ratio of 1:0.8:2.5 were introduced to deposit a second front doped layer doped with element phosphorus as an amorphous silicon layer with a thickness of 20 nm to 80 nm, where a deposition time period was 250 s to 350 s.

Layer 5: Using PECVD, SiH₄, NH₃, and N₂O in a volume ratio of 1:4:7 were introduced to deposit a silicon oxynitride layer as a front mask layer with a thickness of 5 nm to 40 nm, where a deposition time period was 60 s to 200 s.

Alkali polishing: Using a chain-type HF machine, the front mask layer wrapping around the back surface was removed with a hydrofluoric acid solution in a volume percentage of 5%. Then the N-type substrate was transferred to a tank-type alkali polishing machine. The back surface of the N-type substrate was polished at a temperature of 80 °C for 7 minutes using sodium hydroxide and alkali polishing additive BP31 in a volume ratio of 3:1. Meanwhile, the second front doped layer, first front doped layer, front intrinsic layer, and first dielectric layer that wrap around the back surface and edges were removed.

Depositing a second passivating contact structure using PECVD: Films were deposited on the back surface of the N-type substrate in a tubular PECVD apparatus under a pressure ranging from 2500 mTorr to 3500 mTorr at a temperature ranging from 330 °C to 450 °C, where the total deposition time period was 30 min to 60 min.

Layer 1: Using PECVD, 8 SLM to 15 SLM of N₂O was introduced to deposit a second dielectric layer of SiOₓ with a thickness of 2.5 nm, where the deposition time period was 350 s to 600 s.

Layer 2: Using PECVD, SiH₄ and H₂ in a volume ratio of 1:2.5 were introduced to deposit a back intrinsic layer as an amorphous film with a thickness of 5 nm to 40 nm, where the deposition time period was 40 s to 90 s.

Layer 3: Using PECVD, SiH₄, B₂H₆, and H₂ in a volume ratio of 1:0.3:2.5 were introduced to deposit a first back doped layer doped with element boron as an amorphous silicon film with a thickness of 10 nm to 80 nm, where the deposition time period was 80 s to 300 s.

Layer 4: Using PECVD, SiH₄, B₂H₆, and H₂ in a volume ratio of 1:0.6:2.5 were introduced to deposit a second back doped layer doped with element boron as an amorphous silicon film with a thickness of 60 nm to 180 nm, where a deposition time period was 500 s to 700 s.

Layer 5: Using PECVD, SiH₄, NH₃, and N₂O in a volume ratio of 1:4:7 were introduced to deposit a silicon oxynitride layer as a back mask layer with a thickness of 5 nm to 40 nm, where a deposition time period was 60 s to 200 s.

Annealing: In a tubular annealing furnace, annealing was conducted at a annealing temperature of 850 °C for 120 minutes in an atmosphere of 10 SLM nitrogen gas, so that the first doped amorphous silicon layer was transformed into an first doped polysilicon layer, the second doped amorphous silicon layer was transformed into a second doped polysilicon layer, the first dielectric layer and the first doped polysilicon layer constituted the first passivating contact structure, the second dielectric layer and the second doped polysilicon layer constituted the second passivating contact structure, and a PN junction was formed between the N-type substrate and the second doped polysilicon layer.

Printing: A patterned acid-resistant paste was screen printed in the preset region of the front mask layer. The resulting pattern is similar or identical to the pattern of the first electrode to be screen printed, and the width of the printed acid-resistant paste is in a range from 20 µm to 110 µm, slightly wider than the width of the first electrode pattern to be screen-printed. After printing, the printed acid-resistant paste was dried at 150 °C to 250 °C for 10 s. The acid-resistant paste can protect the first dielectric layer and the first doped amorphous silicon layer, i.e., the films such as the front mask layer, the front intrinsic layer, the first front doped layer, and the second front doped layer under the acid-resistant paste. The preset region corresponded to the region where the metal electrode was to be disposed in the solar cell.

Cleaning: Using a chain-type apparatus, a portion of the front mask layer was removed using a hydrofluoric acid solution with a volume percentage of 5%, leaving only the patterned portion on the light-receiving surface unetched due to the protection of the acid-resistant paste. Then the N-type substrate was transferred into a tank-type texturing machine, the first dielectric layer and the first doped amorphous silicon layer that were uncovered in the preset region on the light-receiving surface and the acid-resistant paste were etched away at a temperature of 80 °C for an etching time period of 2 minutes using sodium hydroxide and texturing additive TS40 in a volume ratio of 2:1. Then the N-type substrate was transferred into an acid tank, the back mask layer on the back surface and the remaining front mask layer on the light-receiving surface were etched away using a hydrofluoric acid solution with a volume percentage of 5%, so that a first dielectric layer and a first doped amorphous silicon layer in the preset region were formed on the light-receiving surface of the N-type substrate in sequence, while a second dielectric layer and a second doped amorphous silicon layer were formed on the entire back surface of the N-type substrate in sequence.

### Post-treatment:

Using atomic layer deposition (ALD), aluminum oxide layers were deposited as a first passivation layer and a second passivation layer on the light-receiving surface and the back surface, respectively, at a temperature of 200 °C to 280 °C, with a thickness of 3 nm to 5 nm.

Using PECVD, a silicon nitride layer, a silicon oxynitride layer, and a silicon oxide layer, as a first anti-reflection layer, were deposited in sequence on the first passivation layer. The total thickness of the first anti-reflection layer was in a range from 75 nm to 85 nm, with a refractive index of 1.95 to 2.00. Using PECVD, silicon nitride, as a second anti-reflection layer, was deposited on the second passivation layer. The second anti-reflection layer had a thickness of 75 nm to 80 nm and a refractive index of 2.10 to 2.15.

Screen printing: A silver paste was printed on the back surface and on the light-receiving surface sequentially, and then sintered at 840 °C to form the second electrode and the first electrode, respectively, wherein the first electrode extended through the first anti-reflection layer and the first passivation layer and formed an ohmic contact with the first doped polysilicon layer located in the preset region, and the second electrode extended through the second anti-reflection layer and the second passivation layer and formed an ohmic contact with the second doped polysilicon layer located in the preset region. The cell was subjected to light injection at a temperature of 700 °C. The number of gridlines of the second electrode was 1.4 times that of gridlines of the first electrode.

In the solar cell of this example, the parameters of the passivating contact structure, including layer thickness, doping concentration, through-hole parameters, etc., are detailed in Table 1 below.

The differences between Examples 4 to 14 and Example 1 are detailed in Table 1 below.

### Comparative Example 1

This comparative example provides an N-type passivated contact TOPCon solar cell. The method for preparing the same included the following steps:

Providing an N-type substrate: An N-type 182-size M10 silicon wafer was used as the N-type substrate, with a resistivity ranging from 0.3 Ω·cm to 2.1 Ω·cm and a minority carrier lifetime of >1 ms. The N-type substrate has a front surface and a back surface disposed opposite to each other, with the front surface serving as a light-incident surface.

Texturing: In a tank-type apparatus, the front surface of the N-type substrate was textured using sodium hydroxide and texturing additive TS40 in a volume ratio of 7:1 at a temperature of 80 °C for 7 minutes, during which the thickness reduction was controlled to 5 µm.

Boron diffusion: The textured N-type substrate was placed in a boron diffusion furnace. Using boron trichloride gas and oxygen gas in a volume ratio of 1:3, a boron source was deposited at 830 °C and then driven into the N-type substrate for 1 hour at 1030 °C to form a PN junction. After diffusion, the sheet resistance was controlled to 120 Ω/sq to 140 Ω/sq.

Alkali polishing: Using a chain-type HF machine, the borosilicate glass wrapping around the back surface during the boron diffusion was removed using a hydrofluoric acid solution with a volume percentage of 5%. Then the N-type substrate was transferred by a mechanical arm to a tank-type alkali polishing machine. The back surface was polished at a temperature of 80 °C for 7 minutes using sodium hydroxide and alkali polishing additive BP31 in a volume ratio of 3:1 to remove the PN junction wrapping around the back surface and edges during the boron diffusion.

Forming a tunneling oxide layer and a doped polysilicon layer on the back surface: Three films were deposited on the back surface of the N-type substrate in a tubular PECVD apparatus under a pressure ranging from 2500 mTorr to 3500 mTorr, and the outermost PECVD-deposited mask layer was not to be grown. The three films were deposited at a temperature ranging from 350 °C to 450 °C for total time of 35 min to 60 min, with the deposition time is 705 s.

Layer 1: Using PECVD, 8 SLM to 15 SLM of nitric oxide was introduced for about 140 s to deposit a tunneling oxide layer of SiOₓ with a thickness of 1 nm.

Layer 2: Using PECVD, SiH₄ and H₂ in a volume ratio of about 1:2.5 were introduced for about 65 s to deposit an intrinsic amorphous silicon film with a thickness of 20 nm.

Layer 3: Using PECVD, SiH₄, PH₃, and H₂ in a volume ratio of 1:0.8:2.5 were introduced for about 500 s to deposit a phosphorus-doped amorphous silicon film with a thickness of 100 nm.

Layer 4: Using PECVD, SiH₄ and N₂O in a volume ratio of 1:4.5 were introduced for about 60 s to deposit SiOₓ film with a thickness of 20 nm.

Annealing: In a tubular annealing furnace, the silicon wafer was annealed at a temperature of 850 °C to 950 °C for 2700 s, i.e., 120 minutes, in an atmosphere of 5 SLM nitrogen gas, so that the crystal structure of the deposited amorphous silicon film was transformed, forming a phosphorus-doped polysilicon layer.

Cleaning: Using a chain-type apparatus, the oxide layer on the front surface was removed using a hydrofluoric acid solution with a volume percentage of 5%. Then the silicon wafer was transferred by a mechanical arm into a tank-type alkaline polishing machine, the doped polysilicon layer wrapped around the front surface during the deposition was removed at a temperature of 80°C for 2 minutes using sodium hydroxide and alkaline polishing additive BP31 in a volume ratio of 2:1. Then the silicon wafer was transferred into an acid tank, the BSG layer on the front surface and the back mask layer were removed using a hydrofluoric acid solution with a volume percentage of 5%.

Depositing aluminum oxide film and silicon nitride film on front surface: An aluminum oxide film with a thickness of 5 nm was deposited by atomic layer deposition (ALD) for passivation. Subsequently, a silicon nitride film, a silicon oxynitride film, and a silicon oxide film were sequentially deposited on the front surface by PECVD for anti-reflection, with a total thickness of 75 nm to 85 nm, and a refractive index of 1.95 to 2.00.

Depositing silicon nitride film on back surface by PECVD: A SiNx film was deposited by PECVD for back hydrogen passivation, with a thickness of 75 nm to 80 nm and a refractive index of 2.10 to 2.15.

Screen printing: A silver paste was printed on the back surface and the front surface sequentially, and then sintered at a temperature of 840 °C to form the first electrode and the second electrode, respectively. The cell was subjected to light injection at a temperature of 700 °C. The first electrode forms an ohmic contact with the PN junction region, and the second electrode forms an ohmic contact with the phosphorus-doped polysilicon layer.

That is to say, the preparation method of Comparative Example 1 involved forming the PN junction through drive-in boron diffusion on the front surface of the N-type substrate, then forming a passivating contact structure composed of the first dielectric layer and a phosphorus-doped polysilicon layer through processes such as PECVD and annealing on the back surface of the N-type substrate, so that Comparative Example 1 formed a passivated contact solar cell.

### Comparative Example 2

The difference of this comparative example from Example 1 lies solely in that: the thickness of the first dielectric layer on the light-receiving surface is 2.2 nm.

### Comparative Example 3

The difference of this comparative example from Example 1 lies solely in that: the thickness of the second dielectric layer on the back surface is 1.5 nm.

### Comparative Example 4

The difference of this comparative example from Example 1 lies solely in that: the doping concentration of the P-type conductive element in the second doped polysilicon layer on the back surface is 1×10¹⁸ atoms/cm³.

### Performance testing:

Doping concentration was measured through conventional ECV equipment, i.e., the doping concentration distribution was measured using an electrochemical capacitance-voltage method.

Diameter and quantity of through-holes: The sample was etched with a tetramethylammonium hydroxide (TMAH) solution to remove the doped polysilicon. Subsequently, the sample without the doped polysilicon was placed under a scanning electron microscope (SEM) and observed to measure the diameter and quantity of the holes. The number of holes per unit area was calculated by dividing the quantity of the holes by the observed testing area.

**Table 1. Parameters of the passivating contact structures in solar cells**

| Group | Thickness of first dielectric layer (nm) | Thickness of first doped polysilicon layer (nm) | Diameter of through-hole (nm) | Quantity of through-hole (/cm²) | Thicknes s of second dielectric layer (nm) | Thickness of second doped polysilicon layer (nm) | Doping concentrati on of second doped polysilicon layer (atoms/cm ³) |
|---|---|---|---|---|---|---|---|
| Examples 1 to 3 | 1.5 | 100 | 60 | 1×10⁶ | 2.5 | 300 | 1×10¹⁹ |
| Example 4 | 1.0 | 100 | 60 | 1×10⁶ | 2.5 | 300 | 1×10¹⁹ |
| Example 5 | 2.0 | 100 | 60 | 1×10⁶ | 2.5 | 300 | 1×10¹⁹ |
| Example 6 | 1.5 | 50 | 60 | 1×10⁶ | 2.5 | 300 | 1×10¹⁹ |
| Example 7 | 1.5 | 200 | 60 | 1×10⁶ | 2.5 | 300 | 1×10¹⁹ |
| Example 8 | 1.5 | 100 | 60 | 1×10⁶ | 2.2 | 300 | 1×10¹⁹ |
| Example 9 | 1.5 | 100 | 60 | 1×10⁶ | 3.5 | 300 | 1×10¹⁹ |
| Example 10 | 1.5 | 100 | 60 | 1×10⁶ | 2.5 | 250 | 1×10¹⁹ |
| Example 11 | 1.5 | 100 | 60 | 1×10⁶ | 2.5 | 350 | 1×10¹⁹ |
| Example 12 | 1.5 | 100 | 60 | 1×10⁶ | 2.5 | 300 | 5×10¹⁸ |
| Example 13 | 1.5 | 100 | 60 | 1×10⁷ | 2.5 | 300 | 1×10¹⁹ |
| Example 14 | 1.5 | 100 | 60 | 1×10⁵ | 2.5 | 300 | 1×10¹⁹ |
| Comparati ve Example 2 | 2.2 | 100 | 60 | 1×10⁶ | 2.5 | 300 | 1×10¹⁹ |
| Comparati ve Example 3 | 1.5 | 100 | 60 | 1×10⁶ | 1.7 | 300 | 1×10¹⁹ |
| Comparati ve Example 4 | 1.5 | 100 | 60 | 1×10⁶ | 2.5 | 300 | 1×10¹⁸ |

The solar cells of the above embodiments and comparative examples were subjected to performance testing. The performance parameters such as open-circuit voltage, short-circuit current, and fill factor were measured using Halm testing and sorting equipment. The Halm equipment can simulate sunlight and is equipped with electronic loads, data acquisition, and computing systems for testing the electrical performance of photovoltaic devices (including solar cells). The tested silicon wafers of the solar cells were of 182-size, and the calibrated light intensity was 1000 ± 5 W/m². The experimental results are shown in Table 2 below, where Eta represents photoelectric conversion efficiency, Voc represents open-circuit voltage, Jsc represents short-circuit current, and FF represents fill factor.

**Table 2. Performance testing results of solar cells**

| Sample No. | Open-circuit voltage (V) | Short-circuit current (mA/cm2) | Fill factor (%) | Photoelectric conversion efficiency (%) |
|---|---|---|---|---|
| Example 1 | 0.7250 | 41.53 | 85.16 | 25.64 |
| Example 2 | 0.7257 | 41.54 | 85.12 | 25.66 |
| Example 3 | 0.7256 | 41.53 | 85.22 | 25.68 |
| Example 4 | 0.7231 | 41.53 | 85.09 | 25.55 |
| Example 5 | 0.7261 | 41.53 | 84.53 | 25.49 |
| Example 6 | 0.7219 | 41.52 | 84.61 | 25.36 |
| Example 7 | 0.7262 | 41.22 | 85.17 | 25.49 |
| Example 8 | 0.7235 | 41.53 | 85.17 | 25.59 |
| Example 9 | 0.7255 | 41.53 | 84.33 | 25.41 |
| Example 10 | 0.7252 | 41.61 | 84.60 | 25.53 |
| Example 11 | 0.7260 | 41.33 | 85.20 | 25.56 |
| Example 12 | 0.7233 | 41.57 | 84.21 | 25.32 |
| Example 13 | 0.7230 | 41.53 | 85.09 | 25.55 |
| Example 14 | 0.7261 | 41.53 | 83.56 | 25.20 |
| Comparative Example 1 | 0.7184 | 41.45 | 84.32 | 25.11 |
| Comparative Example 2 | 0.7260 | 41.53 | 83.87 | 25.29 |
| Comparative Example 3 | 0.7225 | 41.53 | 84.32 | 25.30 |
| Comparative Example 4 | 0.7215 | 41.60 | 83.21 | 24.97 |

The performance testing results in Table 1 are analyzed as follows:

Compared with the passivated contact solar cell of Comparative Example 1 where a PN junction is formed on the front surface and a passivation contact structure is formed only on the back surface, the solar cells prepared by the preparation methods of Example 1, Example 2, and Example 3 of the present application have a double-sided passivating contact structure, with a local passivating contact structure on the front surface and a back PN junction structure on an entirety of the back surface, which results in significantly improved parameters such as open-circuit voltage, fill factor, and photoelectric conversion efficiency. Due to the double-sided passivating contact in Examples 1 to 3, metallization-induced recombination on the front surface is substantially reduced, leading to significantly increased open-circuit voltage by approximately 7 mV compared to Comparative Example 1, which is a notable improvement. Additionally, the combination of double-sided passivating contact with the passivated contact PN junction structure on an entirety of the back surface enables electrical conduction across the entire silicon wafer, reducing minority carrier transport loss towards the front local metal contacts. Consequently, the fill factor also shows a significant increase (by approximately 0.8% to 0.9% compared to Comparative Example 1). The combined effect of the above two factors enables the solar cells of the examples of the present application to achieve a photoelectric conversion greater than 25.1%, or even exceeding 25.6%, thereby reducing the cost of the solar cells per watt.

Furthermore, by comparing Examples 1 to 5, it can be seen that the photoelectric conversion efficiency of the solar cells initially increases and then decrease as the thickness of the first dielectric layer increases. The highest photoelectric conversion efficiency is achieved when the thickness of the first dielectric layer is 1.5 nm. Further comparison with Comparative Example 2 shows that when the thickness of the first dielectric layer exceeds 2 nm, the open-circuit voltage, fill factor, and photoelectric conversion efficiency all decrease significantly. Thus, the first dielectric layer with a thickness less than or equal to 2 nm has a better effect on improving indicators such as photoelectric conversion efficiency. Especially, the first dielectric layer with a thickness of 1.5 nm exhibits more significant improvement.

By comparing Examples 1 with Comparative Example 3, it can be seen that, in Comparative Example 3, the thickness of the second dielectric layer is 1.7 nm, but the corresponding photoelectric conversion efficiency is relatively low, indicating that the thickness of the second dielectric layer can be greater than 2 nm to effectively improve the photoelectric conversion efficiency of the solar cell. Furthermore, comparison with Examples 8 and 9, although the photoelectric conversion efficiency of the solar cell is significantly improved when the thickness of the second dielectric layer is 3.5 nm, the improvement in photoelectric conversion efficiency is even more significant when the thickness of the second dielectric layer is 2.5 nm, as in Example 1.

By comparing Example 1 and Comparative Example 4, it can be seen that, the doping concentration of the P-type conductive element in the second doped polysilicon layer can also significantly affect the performance of the solar cell, such as the photoelectric conversion efficiency. In Comparative Example4, the doping concentration of the P-type conductive element in the second doped polysilicon layer is relatively low, which hinders effective selection of electrons and holes and affects the transport efficiency of holes as majority carriers on the back surface, thereby limiting the improvement in photoelectric conversion efficiency. Further comparison with Example 11 shows that when the doping concentration of the P-type element is higher, at 1×10¹⁹ atoms/cm³, it is more beneficial for improving photoelectric conversion efficiency.

By comparing Example 1, Example 6, and Example 7, as well as comparing Example 1, Example 10, and Example 11, it can be seen that different thicknesses of the first doped polysilicon layer and the second doped polysilicon layer can also affect the photoelectric conversion efficiency of the solar cell to varying degrees. The thickness of the first doped polysilicon layer has a particularly significant impact. Preferably, when the thickness of the first doped polysilicon layer is 100 nm and the thickness of the second doped polysilicon layer is 300 nm, the improvement in photoelectric conversion efficiency is more pronounced.

By comparing Example 1, Example 12, and Example 13, it can be seen that the number of through-holes in the second dielectric layer can also affect the photoelectric conversion efficiency of the solar cell. In the present application, when the number of through-holes is 1×10⁶/cm³, the hole transport and passivation effects are balanced better.

The solar cell, its preparation method, and the photovoltaic module disclosed in the embodiments of the present application have been described in detail hereinbefore. Specific examples are provided to illustrate the principles and implementation of the present application and the description of the above embodiments is only intended to aid understanding of the technical solutions and concept of the present application. Those of ordinary skill in the art can modify the specific embodiments and application scope based on the concept of the present application. In summary, the content of this specification should not be construed as limiting the scope of the present application.

## Claims

1. a solar cell, comprising:
a substrate having an N-type conductivity;
a patterned first passivating contact structure disposed on a light-receiving surface of the substrate, the first passivating contact structure comprising a first dielectric layer disposed adjacent to the substrate, and a first doped polysilicon layer disposed away from the substrate and having the N-type conductivity, wherein a thickness of the first dielectric layer is less than or equal to 2 nm;
a second passivating contact structure disposed on an entirety of a back surface of the substrate, the second passivating contact structure comprising a second dielectric layer disposed adjacent to the substrate and a second doped polysilicon layer disposed away from the substrate, the second doped polysilicon layer having a P-type conductivity different from the N-type conductivity to form a PN junction between the second doped polysilicon layer and the substrate, wherein a thickness of the second dielectric layer is greater than 2 nm, the second dielectric layer has a through-hole that communicates the substrate with the second doped polysilicon layer, and a doping concentration of a P-type conductive element in the second doped polysilicon layer is in a range from 5×10¹⁸ atoms/cm³ to 3×10²⁰ atoms/cm³;
a first function layer disposed on the light-receiving surface of the substrate and a surface of the first doped polysilicon layer away from the substrate;
a second function layer disposed on a surface of the second doped polysilicon layer away from the substrate;
a first electrode extending through the first function layer and forming an ohmic contact with the first doped polysilicon layer, wherein a patterned region of the first passivating contact structure is disposed corresponding to a patterned region of the first electrode; and
a second electrode extending through the second function layer and forming an ohmic contact with the second doped polysilicon layer.

2. The solar cell according to claim 1, wherein a region of the substrate covered by the first passivating contact structure is 0.5 µm to 1.5 µm thicker than another region of the substrate uncovered by the first passivating contact structure.

3. The solar cell according to claim 1, wherein a diameter of the through-hole is in a range from 50 nm to 500 nm, and a number of the through-holes is in a range from 1×10⁴ /cm² to 1.6×10⁸ /cm².

4. The solar cell according to claim 1, wherein a thickness of the first doped polysilicon layer is in a range from 40 nm to 200 nm.

5. The solar cell according to claim 1, wherein a thickness of the second doped polysilicon layer is in a range from 200 nm to 400 nm.

6. The solar cell according to claim 1, wherein the first doped polysilicon layer is doped with an N-type conductive element, wherein the N-type conductive element comprises at least one of a phosphorus element, a germanium element, or a selenium element.

7. The solar cell according to claim 1, wherein the P-type conductive element comprises at least one of a boron element, an indium element, or a gallium element.

8. The solar cell according to claim 1, wherein a width of the first passivating contact structure is in a range from 20 µm to 110 µm.

9. The solar cell according to any one of claims 1 to 8, wherein the first function layer comprises a first passivation layer disposed adjacent to the substrate and a first anti-reflection layer disposed away from the substrate.

10. The solar cell according to any one of claims 1 to 8, wherein the second function layer comprises a second passivation layer disposed adjacent to the second doped polysilicon layer and a second anti-reflection layer disposed away from the second doped polysilicon layer.

11. The solar cell according to any one of claims 1 to 8, wherein a quantity ratio of gridlines of the second electrode to gridlines of the first electrode is in a range from 1.2:1 to 1.6:1.

12. A method for preparing the solar cell according to any one of claims 1 to 11, comprising following steps:
forming the passivating contact structure: forming a first passivating contact structure by disposing the first dielectric layer and a first doped amorphous silicon layer in sequence on a light-receiving surface of the substrate, and forming a second passivating contact structure by disposing the second dielectric layer and a second doped amorphous silicon layer in sequence on the back surface of the substrate, wherein a thickness of the first dielectric layer is less than or equal to 2 nm and a thickness of the second dielectric layer is greater than 2 nm;
annealing and patterning treatments: annealing the substrate on which the first passivating contact structure and/or the second passivating contact structure are formed to convert the first doped amorphous silicon layer into the first doped polysilicon layer, and/or to convert the second doped amorphous silicon layer into the second doped polysilicon layer, and patterning the first passivating contact structure to obtain a patterned first passivating contact structure; and
post-treatment: forming the first function layer on the light-receiving surface of the substrate and the patterned first doped polysilicon layer, forming the second function layer on the second doped polysilicon layer, and fabricating the first electrode on the first function layer and the second electrode on the second function layer.

13. The method for preparing the solar cell according to claim 12, wherein the step of forming the passivating contact structure comprises:
alkali polishing: polishing the light-receiving surface and the back surface of the substrate using a first alkali agent;
depositing the second passivating contact structure: depositing the second dielectric layer and the second doped amorphous silicon layer in sequence on the back surface of the substrate;
texturing: removing the second doped amorphous silicon layer and the second dielectric layer that wrap around the light-receiving surface and edges using a first acid agent, and then texturing the light-receiving surface of the substrate using a second alkali agent; and
depositing the first passivating contact structure: depositing the first dielectric layer and the first doped amorphous silicon layer in sequence on the textured light-receiving surface.

14. The method for preparing the solar cell according to claim 13, wherein the step of depositing the second passivating contact structure comprises depositing the second dielectric layer, a back intrinsic layer, a back doped layer doped with the P-type conductive element, and a back mask layer in sequence on the alkali-polished back surface by plasma enhanced chemical vapor deposition (PECVD);
the texturing step comprises removing the back mask layer, the back doped layer, the back intrinsic layer, and the second dielectric layer that wrap around the light-receiving surface and edges using the first acid agent, and then texturing the light-receiving surface using the second alkali agent; and
the step of depositing the first passivating contact structure comprises depositing the first dielectric layer, a front intrinsic layer and a front doped layer doped with a N-type conductive element in sequence on the textured light-receiving surface by PECVD.

15. The method for preparing the solar cell according to claim 14, the step of annealing and patterning treatments comprises:
printing: printing a patterned alkali-resistant paste on a preset region of the front doped layer, and drying to cure the alkali-resistant paste;
cleaning: etching away the first doped amorphous silicon layer, the first dielectric layer and a portion of the substrate uncovered by the preset region of the light-receiving surface using a third alkali agent, then etching away the alkali-resistant paste and the back mask layer on the back surface using a second acid agent, to form a patterned first dielectric layer and a patterned first doped amorphous silicon layer on the light-receiving surface of the substrate, wherein a portion of the substrate located in the preset region is 0.5 µm to 1.5 µm thicker than a portion of the substrate uncovered by the preset region, and the second dielectric layer and the second doped amorphous silicon layer are formed on an entirety of the back surface of the substrate; and
annealing: annealing at 850°C to 1000°C in an inert atmosphere for 90 min to 150 min, to convert the first doped amorphous silicon layer into the first doped polysilicon layer, or to convert the second doped amorphous silicon layer into the second doped polysilicon layer, and to form a PN junction between the substrate and the second doped polysilicon layer.

16. The method for preparing the solar cell according to claim 15, wherein in the printing step, a width of the printed patterned alkali-resistant paste is in a range from 20 µm to 110 µm, and after printing, drying is performed at a temperature in a range from 150 °C to 250 °C for a time period in a range from 8 seconds to 12 seconds.

17. The method for preparing the solar cell according to claim 15, wherein in the cleaning step, the third alkali agent comprises an alkali metal hydroxide and a texturing additive in a volume ratio from 1:1 to 3:1, and the etching using the third alkali agent is performed at a temperature from 70°C to 90°C for 1 min to 3 min.

18. The method for preparing the solar cell according to claim 15, wherein in the cleaning step, the second acid agent is a hydrofluoric acid solution with a volume percentage of 4% to 6%.

19. The method for preparing the solar cell according to claim 13, wherein the step of depositing the second passivating contact structure comprises: first forming, on the alkali polished back surface, the second dielectric layer through a thermal oxidation process and then a back intrinsic amorphous silicon layer through LPCVD, and then doping the back intrinsic amorphous silicon layer with a P-type conductive element through a diffusion process, to convert the back intrinsic amorphous silicon layer into the second doped polysilicon layer;
the texturing step comprises removing the second doped polysilicon layer and the second dielectric layer that wrap around the light-receiving surface and edges using the first acid agent, then texturing the light-receiving surface using the second alkali agent; and
the step of depositing the first passivating contact structure comprises depositing the first dielectric layer, a front intrinsic layer, a front doped layer doped with a N-type conductive element, and a front mask layer in sequence on the textured light-receiving surface by PECVD.

20. The method for preparing the solar cell according to claim 19, wherein the step of annealing and patterning treatment comprises:
annealing: annealing at 850°C to 950°C in an inert atmosphere for 90 min to 150 min, to convert the first doped amorphous silicon layer into the first doped polysilicon layer;
printing: printing a patterned acid-resistant paste on a preset region of the front mask layer, and drying to cure the acid-resistant paste;
cleaning: etching away the front mask layer uncovered in the preset region of the light-receiving surface using a third acid agent, then etching away the first doped polysilicon layer, and the first dielectric layer that are not covered in the preset region of the light-receiving surface and the acid-resistant paste using a fourth alkali agent, and removing the remaining front mask layer using a fourth acid agent, to form a patterned first dielectric layer and a patterned first doped amorphous silicon layer on the light-receiving surface of the substrate and a second dielectric layer and a second doped polysilicon layer on a front of the back surface of the substrate.

21. The method for preparing the solar cell according to claim 20, wherein in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

22. The method for preparing the solar cell according to claim 20, wherein in the cleaning step, the third acid agent is a hydrofluoric acid solution with a volume percentage of 4% to 6%.

23. The method for preparing the solar cell according to claim 20, wherein in the cleaning step, the fourth alkali agent comprises an alkali metal hydroxide and a texturing additive in a volume ratio from 1:1 to 3:1, and the etching using the fourth alkali agent is performed at a temperature from 70 °C to 90 °C for 1 min to 3 min.

24. The method for preparing the solar cell according to claim 20, wherein in the cleaning step, the fourth acid agent is a hydrofluoric acid solution with a volume percentage of 4% to 6%.

25. The method for preparing the solar cell according to claim 12, wherein the step of forming the passivating contact structure comprises:
texturing: texturing the substrate using a fifth alkali agent;
depositing the first passivating contact structure: depositing the first dielectric layer and the first doped amorphous silicon layer in sequence on the textured light-receiving surface;
alkali polishing: removing a portion of the first doped amorphous silicon layer wrapping around the back surface using a fifth acid agent, then polishing the back surface of the substrate using a sixth alkali agent, and removing the remaining first doped amorphous silicon layer and the first dielectric layer that wrap around the back surface and edges; and
depositing the second passivating contact structure: depositing the second dielectric layer, and the second doped amorphous silicon layer in sequence on the back surface.

26. The method for preparing the solar cell according to claim 25, wherein the step of depositing the first passivating contact structure comprises depositing the first dielectric layer, a front intrinsic layer, a front doped layer doped with a N-type conductive element, and a front mask layer in sequence on the textured light-receiving surface by PECVD;
the step of alkali polishing comprises removing the front mask layer wrapping around the back surface using the fifth acid agent, then polishing the back surface of the substrate using the sixth alkali agent, and removing the front doped layer, the front intrinsic layer, and the first dielectric layer that wrap around the back surface and edges; and
depositing the second passivating contact structure comprises depositing the second dielectric layer, a back intrinsic layer, a back doped layer doped with a P-type conductive element, and a back mask layer in sequence on the alkali-polished back surface by PECVD.

27. The method for preparing the solar cell according to claim 26, wherein the step of annealing and patterning treatment comprises:
annealing: annealing the substrate on which the first and second passivating contact structures are formed at 850°C to 1000°C in an inert atmosphere for 90 min to 150 min;
printing: printing a patterned acid-resistant paste in the preset region of the front mask layer, and drying to cure the acid-resistant paste; and
cleaning: etching away the front mask layer uncovered in the preset region of the light-receiving surface using a sixth acid agent, then etching away the acid-resistant paste, and the first dielectric layer and the first doped amorphous silicon layer that are not covered in the preset region of the light-receiving surface using a seventh alkali agent, and removing the front mask layer and the back mask layer using a seventh acid agent.

28. The method for preparing the solar cell according to claim 27, wherein in the printing step, a width of the printed patterned acid-resistant paste is in a range from 20 µm to 110 µm, and after printing, drying is performed at a temperature in a range from 150 °C to 250 °C for a time period in a range from 8 seconds to 12 seconds.

29. The method for preparing the solar cell according to claim 27, wherein in the cleaning step, the sixth acid agent is a hydrofluoric acid solution with a volume percentage of 4% to 6%.

30. The method for preparing the solar cell according to claim 27, wherein in the cleaning step, the seventh alkali agent comprises an alkali metal hydroxide and a texturing additive in a volume ratio from 1:1 to 3:1, and the etching using the seventh alkali agent is performed at a temperature from 70 °C to 90 °C for 1 min to 3 min.

31. The method for preparing the solar cell according to claim 27, wherein in the cleaning step, the seventh acid agent is a hydrofluoric acid solution with a volume percentage of 4% to 6%.

32. The method for preparing the solar cell according to any one of claims 12 to 28, wherein the first function layer comprises a first passivation layer and a first anti-reflection layer, and the second function layer comprises a second passivation layer and a second anti-reflection layer; the post-treatment step comprises:
depositing the first passivation layer and the second passivation layer on the light-receiving surface and the back surface by ALD, respectively;
depositing the first anti-reflection layer on the first passivation layer and the second anti-reflection layer on the second passivation layer by PECVD;
printing the first electrode on the light-receiving surface and forming an ohmic contact between the first electrode and the first doped polysilicon layer; and
printing a second electrode on the back surface and forming an ohmic contact between the second electrode and the second doped polysilicon layer;

33. The method for preparing the solar cell according to claim 32, wherein in the ALD, the depositing is performed at a temperature in a range from 200 °C to 280 °C, and thicknesses of the first passivation layer and the second passivation layer are deposited to a thickness from 3 nm to 5 nm, respectively.

34. A photovoltaic module, comprising the solar cell according to any one of claims 1 to 11, or a solar cell prepared by the method according to any one of claims 12 to 33.
